# EUROPEAN PATENT APPLICATION

(11) **EP 4 841 175 A1**
(43) Date of publication of application: **18.11.2026**
(21) Application number: 25176709.1
(22) Date of filing: 15.05.2025
(51) Int. Cl.: F24F 11/00, G05B 15/02

(54) **SYSTEM AND METHOD FOR IMPROVING INDOOR AIR QUALITY DEPENDANT OF OCCUPANCY**

(71) Applicant: Siemens Schweiz AG, 8047 Zürich (CH)
(72) Inventor: Wang, Dongyu, 5408 Ennetbaden (CH); Tackenberg, Martin, 91301 Forchheim (DE); Yun, Seoyeon, 6330 Cham (CH)
(74) Representative: Siemens Patent Attorneys

(57) **Abstract**

Optimised occupancy. A method of handling indoor air quality (IAQ) within spaces (18a - 18e) of a structure, the method comprising the steps: using a first occupancy schedule and a building model (10) to determine a first set of ventilation rates for the spaces (18a - 18e), wherein the first occupancy schedule specifies a first distribution of a first number of occupants over the spaces (18a - 18e) and wherein the first number of occupants is lower than a maximum number, the maximum number indicating full occupancy of the structure; using a second occupancy schedule and the building model (10) to determine a second set of ventilation rates for the spaces (18a - 18e), wherein the second occupancy schedule specifies a second distribution of the first number of occupants over the spaces (18a - 18e) and wherein the second occupancy schedule is different from the first occupancy schedule.

## Description

### Background

The present disclosure deals with optimised occupancy within buildings such as commercial and/or industrial and/or residential buildings. More specifically, the present disclosure deals with optimised occupancy wherein levels of pollutants and/or energy conversion are optimised.

In many cases, buildings such as commercial and/or industrial buildings comprise energy management systems and/or building management systems. These systems orchestrate supply and demand of power within these buildings. Energy conversion is associated with the operational cost, so optimised supply and demand generally also offers financial benefits. What's more, emissions of greenhouse gases such as CO₂ can be curbed.

In addition to energy conversion, indoor air quality (IAQ) can also be controlled by state-of-the-art systems. To that end, sensors recording levels of CO₂ can be deployed in the supply and return ducts as well as in the rooms and/or zones of these buildings. The sensors send readings to a building management system, the latter system implementing an optimisation strategy. Management of indoor air quality entails improved comfort and improves on building occupants' productivity, especially in commercial and/or industrial buildings.

The commercial real estate sector continues to struggle with high vacancy rates. Vacancy rates have reached around 15-20% in 2024, with home office and remote work remaining popular with personnel despite increasing return-to-office mandates by employers.

The resulting partial occupancy in buildings can pose several challenges for building owners and operators: Reduced income, space under-utilization, lowered energy efficiency, and increased security risks. These challenges will likely not disappear: Well before the Covid-19 pandemic, a study observed actual occupancy levels to range from one third to two thirds of the expected full occupancy during building design. The study was published by O'Brien and co-authors in a publication Science and Technology for the Built Environment in 2019.

One method to reduce energy waste under partial occupancy conditions is to apply demand-controlled ventilation (DCV) systems. Demand-controlled ventilation uses the indoor CO₂ concentrations as an indicator for adjusting the outdoor air supply. Ideally, CO₂ levels remain at or below a threshold value, which depends on the regulations or guidelines being followed. In many cases, occupants are the primary source of indoor CO₂ through breathing. Therefore, when there are fewer people indoors, the CO₂ concentrations are lower and the heating, ventilation, and air conditioning (HVAC) system reduces outdoor air supply rate. The system thereby lowers energy conversion under partial occupancy conditions.

While DCV is an energy-efficient ventilation strategy to achieve a target indoor CO₂ level, it may always not be able to maintain a good indoor air quality. What's more, DCV may not be able to maintain a good indoor air quality in an energy-efficient way, especially under partial occupancy conditions.

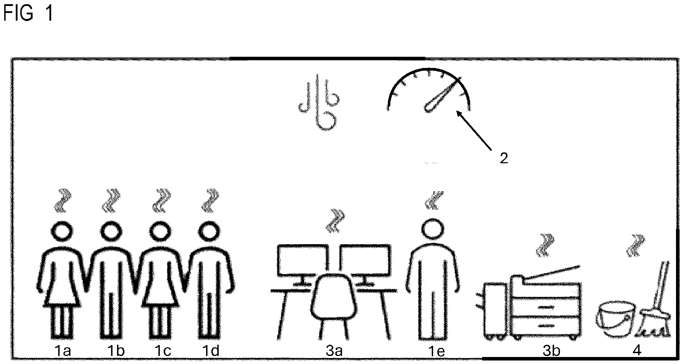

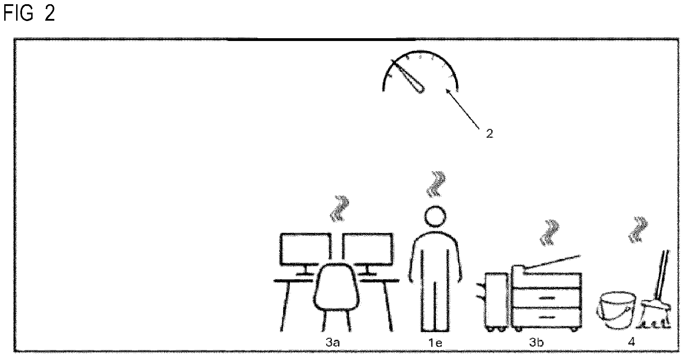

A shortcoming of DCV is illustrated by ways of FIG 1 and FIG 2. FIG 1 shows a zone with full occupancy. Five occupants 1a - 1e are depicted in FIG 1. Accordingly, the indoor CO₂ level as indicated by the CO₂ metre 2 is high. For example, an indoor concentration of CO₂ of 1500 ppm can be measured in this zone. In addition to the CO₂ emissions, occupants 1a - 1e may also emit volatile organic compounds (VOCs). VOCs are also emitted by office equipment such as desks 3a and printers 3b. Additionally, cleaning equipment 4 and detergents can also emit VOCs.

The high concentrations of CO₂ as indicated by metre 2 of FIG 1 will likely trigger DCV to maintain a high fresh air supply rate. Consequently, a CO₂ level can be kept at or below a desired threshold. The high fresh air supply rate also ensures the removal of VOCs, even though VOCs may not be measured or used as an input parameter for DCV operation.

FIG 2 shows the same room or zone with partial occupancy and only a single occupants 1e is depicted in FIG 2. Accordingly, the indoor CO₂ level as indicated by the CO₂ metre 2 is low. For example, an indoor concentration of CO₂ of 600 ppm may be measured in this zone. In addition to the CO₂ emission, occupant 1e may also emit some volatile organic compounds (VOCs). VOCs are still emitted by office equipment such as desks 3a and printers 3b. Additionally, cleaning equipment 4 and detergents can also emit VOCs.

The minimal concentrations of CO₂ as indicated by metre 2 of FIG 2 will likely lead DCV to maintain a low fresh air supply rate. Consequently, volatile organic compounds and other harmful emissions are not removed and accumulate in the room and/or in the zone.

When CO₂ levels are low due to reduced occupancy, outdoor air supply rates are reduced. That reduction in outdoor air supply causes pollutants of primarily indoor origins - including carcinogenic compounds such as aldehydes, emitted by furniture and paints - to accumulate. Especially in buildings built or modernized in the 1960s to 1970s, polychlorinated biphenyls such as PCB138, PCB153 and PCB180 can also accumulate. Occupants are then likely exposed to harm.

This can be particularly pronounced in buildings that do not use low-emitting materials. Furthermore, unlike volatile organic compounds (VOCs) like formaldehyde, there are pollutants that are continuously released into the indoor air well after the end of construction/renovation. Those pollutants include, but are not limited to, semi-volatile organic compounds (SVOCs) and/or intermediate volatility organic compounds (IVOCs). To simplify further discussions, pollutants that are primarily of non-occupant, indoor origins will be referred to as background pollutants emitted by background sources.

If building HVAC operation does not consider partial occupancy, for example at a fixed condition or based on a fixed schedule, power will be wasted. Demand controlled ventilation (based on CO₂ concentration) is used to adjust HVAC operation based on occupancy conditions. However, the suitability of CO₂ concentration as an indicator of IAQ worsens as the occupancy rate decreases, since background sources become more important than occupant-dependent sources.

A common element of known solution is to match HVAC operation and occupancy schedules. A basic but static implementation is to operate HVAC equipment at a minimum capacity outside normal working hours. HVAC equipment can, by way of non-limiting examples, operate at minimum capacity during early morning, lunch breaks, evenings, weekends, and holidays. This implementation can apply to pre-heating and cooling alike. Favourable conditions such as favourable ambient conditions, low prices for power as well as the thermal mass of the building are thereby exploited. For example, a European patent application EP2102568A1 was filed in December 2006 and describes exploitation of favourable ambient conditions via free cooling. Also, a European patent EP4086724B1 was granted in October 2023 and deals with exploiting thermal mass using thermally activated building structures.

Furthermore, one could use passive infrared (PIR) sensors, occupancy density monitors, people counters, or the CO₂ concentration. These measures afford estimates of numbers of occupants, such that a HVAC system can better react to changing demands. However, a reactive system that adjusts outdoor air supply based on occupancy may fail to maintain a healthy environment regardless of how occupancy is measured or estimated. Failure of maintenance of a healthy environment can, under certain partial occupancy conditions, be caused by ineffective removal of background pollutants.

An article published by B LIM and co-authors at the 29^{th} AAAI conference on artificial intelligence deals with HVAC-aware occupancy scheduling. B LIM and co-authors use a mixed-integer linear programming model to optimise schedules and locations of meetings, workshops, classes and exams. It is claimed that substantial reductions in energy conversion are achieved compared to occupancy-based approaches. The article does, however, not factor in pollutants and/or indoor air quality.

Another academic article published by V ERICKSON and co-authors deals with an occupancy-based system for efficient reduction of HVAC energy. The article was published as part of the proceedings of the 10th ACM/IEEE conference on information processing in sensor networks. A strategy that is based on a sensor network such as passive infrared sensors is employed. Real-time data indicative of occupancy is derived using this model. In other words, the approach factors in partial occupancy as opposed to full occupancy. A 42 percent reduction in energy conversion is claimed while applicable comfort standards are maintained. The article is, however, silent on indoor air quality and is silent on pollutants.

Yet another article published by A JINDAL and co-authors deals with a heuristic-based smart HVAC management scheme for university buildings. The article was published as part of the IEEEE transactions on industrial informatics in November 2018. Similarly to the article by B LIM and co-authors, a mixed-integer linear programming problem is formulated. A heuristic-based energy management scheme is proposed and the objective of this scheme is minimise overall energy conversion: $min \sum \sum {E}_{r} {α}_{rt}$

In this expression, *Eᵣ* denotes the rate of energy conversion of a classroom indexed *r. αᵣₜ* denotes the occupancy status of the classroom indexed *r* at time *t*. Neither indoor air quality nor pollutants are factored into the heuristic scheme.

One would try to address these shortcomings by measuring background pollutants and adjusting the outdoor air supply rate. In so doing, the demand-controlled ventilation system can be configured to respond to CO₂, to total VOC, and/or to specific VOCs.

However, this approach will increase not only the capital cost (e.g. additional sensors) but also very possibly the operational cost. Operational cost can increase due to increased outdoor air supply rate and because more sensor devices need to be frequently maintained. What's more, different VOC sensors can fail to produce reproducible and standardised readings.

To provide good air quality in an energy-efficient manner, a HVAC system performs best when the demands to remove occupant-emitted and background pollutants are roughly equal. A demand to remove one group of pollutants can exceed a demand to remove another group of pollutants. These circumstances can result in the former being *under ventilated* and/or the latter being *over ventilated.* Whilst overventilation may be desirable under certain circumstances, such as to minimise the risks of transmitting diseases, underventilation of pollutants potentially causes harm. A DCV system that responds to CO₂ can thus lead to insufficient removal of background pollutants when the CO₂ concentration is low due to partial occupancy.

It would be more optimal to proactively align HVAC operation, occupancy, and background pollutant removal to provide a healthy environment in an energy-efficient manner. This approach is more promising than reactively matching HVAC operation to occupancy.

The instant disclosure provides optimizations of occupancy wherein locations and/or desks and/or rooms and/or spaces and/or zones for personnel are assigned. These optimizations yield benefits in terms of lower rates of energy conversion and/or in terms of reduced levels of background pollutants.

### Summary

The present disclosure deals with occupancy optimised in view of optimal indoor air quality. The optimisation can also factor in rates of energy conversion.

To that end, two or more occupancy schedules are produced or received. The occupancy schedules specify how many occupants are in a space of a structure (at a given time). The occupancy schedules can also specify how many occupants are in a room or in a zone of a building (at a given time).

Also, a building model is provided. The building model provides information about a structure such as floor areas of spaces inside the structure. Likewise, the building model can provide information about a building such as floor areas of rooms and/or of zones inside the building.

Preferably, data indicative of maximum occupancy of the spaces inside or of the structure are provided along with data indicative of floor areas. Ideally, data indicative of maximum occupancy of the rooms inside or of the building are provided along with data indicative of floor areas. Likewise, Preferably, data indicative of maximum occupancy of the zones inside or of the building can be provided along with data indicative of floor areas.

A set of ventilation rates is generated based on each occupancy schedule. That is, ventilation rates for the spaces inside the structure are determined and/or estimated and/or calculated. Likewise, ventilation rates for the rooms inside the building can be determined and/or estimated and/or calculated. Also, ventilation rates for the rooms and/or zones inside the building can be determined and/or estimated and/or calculated.

Also, sets of occupied spaces are determined and/or estimated and/or calculated. These sets matter because air quality of empty spaces needs not be factored in. Likewise, sets of occupied rooms can be determined and/or estimated and/or calculated. Additionally, sets of occupied zones can be determined and/or estimated and/or calculated. These sets matter because air quality of empty rooms and/or zones needs not be factored in.

When empty spaces and sets of ventilation rates are known, ventilation rates and/or characteristic ventilation rates are determined and/or estimated and/or calculated. The (characteristic) ventilation rates can comprise one or more of:
- total ventilation rates of all the spaces of a structure,
- total ventilation rates of all the rooms of a building,
- total ventilation rates of all the zones of a building,
- average ventilation rates of all the spaces of a structure,
- average ventilation rates of all the rooms of a building,
- average ventilation rates of all the zones of a building,
- mean ventilation rates of all the spaces of a structure,
- mean ventilation rates of all the rooms of a building,
- mean ventilation rates of all the zones of a building.

The (characteristic) ventilation rates can also be selected from:
- total ventilation rates of all the spaces of a structure,
- total ventilation rates of all the rooms of a building,
- total ventilation rates of all the zones of a building,
- average ventilation rates of all the spaces of a structure,
- average ventilation rates of all the rooms of a building,
- average ventilation rates of all the zones of a building,
- mean ventilation rates of all the spaces of a structure,
- mean ventilation rates of all the rooms of a building,
- mean ventilation rates of all the zones of a building.

The ventilation rates are then associated with their respective occupancy schedules and compared to one another. Likewise, characteristic ventilation rates can be associated with their respective occupancy schedules and can be compared to one another.

Next, an occupancy schedule is chosen and/or is selected wherein the occupancy schedule is associated with the ventilation rate that secures the best indoor air quality (IAQ). The schedule associated with the best ventilation rate is considered the best IAQ schedule. The best ventilation rate can, in an embodiment, comprise the highest and/or the largest ventilation rate. More specifically, the best ventilation rate can be the highest and/or the largest ventilation rate.

It is also envisaged that the best ventilation rate comprises the highest and/or the largest ventilation rate per occupant. More specifically, the best ventilation rate can be the highest and/or the largest ventilation rate per occupant. It is still envisaged that the best ventilation rate comprises the highest and/or the largest ventilation rate per floor size unit. More specifically, the best ventilation rate can be the highest and/or the largest ventilation rate per floor size unit.

The schedule associated with the best indoor air quality can be forwarded to an occupant and/or to a user. To that end, a graphical user interface on a mobile handheld device is provided. The graphical user interface presents a choice such as a choice of a space, of a room or of a zone. The occupant and/or the user can approve or disapprove the best IAQ schedule, wherein indoor air quality and energy efficiency are factored into the best IAQ schedule. The occupant and/or the user can also approve or disapprove an assignment to a space and/or to a room and/or to a zone. Likewise, the occupant and/or the user can also approve or disapprove a recommended space and/or room and/or zone.

A second-best IAQ occupancy schedule can also be chosen and/or selected. Various schedules such as the best IAQ schedule and the second-best IAQ schedule can be evaluated in terms of energy efficiency.

The best overall schedule can be chosen and/or can be selected from these schedules. Similarly to the best IAQ schedule, the best overall schedule can be forwarded to an occupant and/or to a user. To that end, the graphical user interface on the mobile handheld device is provided. The graphical user interface presents a choice such as a choice of a space, of a room or of a zone. The occupant and/or the user can approve or disapprove the best overall schedule, wherein indoor air quality and energy efficiency are factored into the best overall schedule. The occupant and/or the user can also approve or disapprove an assignment to a space and/or to a room and/or to a zone. Likewise, the occupant and/or the user can also approve or disapprove a recommended space and/or room and/or zone.

Occupants and/or users can be incentivised to follow the assigned and/or the recommended schedules. These incentives can involve tokens such as digital tokens and/or non-fungible tokens and/or utility tokens. Tokens can be stored and/or read and/or accessed using a blockchain, wherein the blockchain can be a public blockchain.

It is envisaged that checks are carried out whether an assignment and/or a recommendation is followed before awarding or removing tokens. These checks can involve checks via an occupancy detector and/or via a CO₂ sensor or similar. There can also be a presence detection sensor mounted to an occupant's and/or to a user's desk. These sensors and/or detectors record signals indicative of occupancy. Where the signals indicative of occupancy match expectations, tokens can be added and/or awarded. Otherwise, tokens can be removed.

### Brief description of the drawings

Various features will become apparent to those skilled in the art from the following detailed description of the disclosed non-limiting embodiments. The drawings that accompany the detailed description can be briefly described as follows:
FIG 1 shows a room or a zone with full occupancy.
FIG 2 shows the same room or the same zone with partial occupancy.
FIG 3 shows a high-level overview of the approach to optimise energy conversion and/or indoor air quality and/or levels of pollutants.
FIG 4 shows a structure and/or a building that is fully occupied.
FIG 5 shows the structure and/or the building with partial occupancy.
FIG 6 shows the structure and/or the building with optimised occupancy.
FIG 7 illustrates a user interface to incentivise occupants and/or users.
FIG 8 shows a pogress tracker to further motivate occupants and/or users.
FIG 9 shows another pogress tracker to further motivate occupants and/or users.

### Detailed description

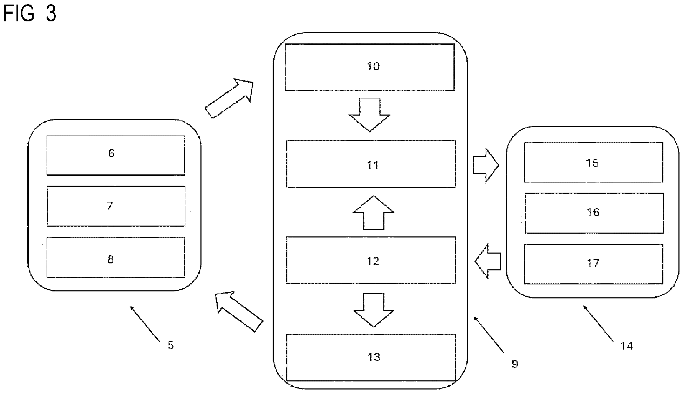

FIG 3 shows a high-level overview of the approach adopted herein. A plethora of system data and/or of algorithmic data 5 is relied on. System data and/or algorithmic data 5 comprise occupancy data 6, data 7 indicative of indoor air-quality and of thermal performance 8. This list is not exhaustive.

Occupancy data 6 can, by way of non-limiting example, comprise data indicative of an occupancy of a space *r* of a structure at a time *t*. More specifically, occupancy data 6 can, by way of non-limiting example, comprise data indicative of an occupancy of a room *r* of a building at a time *t.* In an embodiment, time *t is* specified using regular intervals of a predetermined length such as fifteen minutes or thirty minutes or one hour.

Data 7 indicative of indoor air quality can, by way of non-limiting example comprise data indicative of
- volatile organic compounds (VOC),
- formaldehydes,
- polychlorinated biphenyls such as PCB138, PCB153, PCB180,
- occupant-emitted pollutants,
- CO₂ concentrations.

These concentrations can refer to a space *r* of a structure and to a time *t*. More specifically, these concentrations can refer to a room *r* of a building and to a time *t*. In an embodiment, time *t* is specified using regular intervals of a predetermined length such as fifteen minutes or thirty minutes or one hour. Preferably, the same regular intervals are used to indicate indoor air quality and to indicate occupancy. Ideally, the same regular intervals are also used to indicate levels of pollutants and to indicate occupancy.

Data 8 indicative of thermal performance can, by way of non-limiting example, comprise data indicative of thermal performance of a space *r* of a structure at a time *t*. More specifically, data 8 indicative of thermal performance can, by way of non-limiting example, comprise data indicative of thermal performance of a room *r* of a building at a time *t*. In an embodiment, time *t* is specified using regular intervals of a predetermined length such as fifteen minutes or thirty minutes or one hour. Preferably, the same regular intervals are used to indicate indoor air quality, occupancy and thermal performance. Ideally, the same regular intervals are also used to indicate levels of pollutants and to indicate occupancy.

Preferably, thermal performance of a space *r* of a structure at a time t is indicated in units of power such as Watts, Kilowatts or Megawatts. Likewise, thermal performance of a room *r* of a building at a time *t* can be indicated in units of power such as Watts, Kilowatts or Megawatts. Thermal performance can also be indicated as a percentage of a design rate of energy conversion of the space *r*. For example, thermal performance can be specified as seventy percent or as eighty percent or as ninety percent of a design rate of energy conversion. Likewise, thermal performance of a room *r* of a building at a time t can be indicated as a percentage of a rated power of the room *r*. Thermal performance can also be specified as seventy percent or as eighty percent or as ninety percent of a design rate of energy conversion.

A building thermal model is generally not expected to change substantially unless (extensive) retrofits are carried out. Changes in ambient conditions can, however, require minor adjustments. Large, seasonal variations would typically be captured after one year of operation at the latest.

The system data and/or algorithmic data 5 are processed by various workflow items 9. The workflow items 9 can also produce and/or generate the system data and/or algorithmic data 5. The workflow items 9 comprise a building model 10. The building model 10 advantageously is a building model 10 describing the structure and comprises data indicative of one or more spaces *r* within the structure. The building model 10 can also be a building model 10 of the structure and comprise data indicative of one or more spaces *r* of the structure. The building model 10 ideally is a building model 10 describing the building and comprises data indicative of one or more rooms or zones *r* within the building. The building model 10 can also be a building model 10 of the building and comprise data indicative of one or more rooms or zones *r* of the building.

Generally, the building model 10 is a model representation of the building and/or of any equipment in the building. The building model 10 preferably also comprises an occupancy schedule. The occupancy schedule specifies who is where and when.

It is envisaged that the building model 10 is implemented using a modelling tool such as Modelica. This tool is available on the Internet at https://modelica.org/. The core function of the model 10 is to simulate time-dependent demand for HVAC. That is, the model 10 simulates heating and/or cooling loads, as well as demands for ventilation. The model ideally also simulates one or more of:
- indoor temperature,
- humidity,
- indoor air quality such as concentrations of CO₂, of VOC and/or of particulate matter.

The building model 10 simulates these items under a given occupancy scenario and/or under a given occupancy schedule.

The instant disclosure still discloses any of the workflow items 9 described herein, wherein the building model 10 follows at least one of the standards:
- National Building Information Modeling Standard for the United States of America, published on 18 December 2007, version 2 and/or
- National Building Information Modeling Standard for the United States of America, published in 2015, version 3 and/or
- BIM-reference for Germany, file reference 10.08.17.7-12.08, published in 2013 and/or
- British Standard 8536-2:2016 and/or
- ONORM A 6241-2:2015.

The instant disclosure further discloses any of the workflow items 9 described herein, wherein the building model 10 follows one of the standards
- National Building Information Modeling Standard for the United States of America, published on 18 December 2007, version 2 and/or
- National Building Information Modeling Standard for the United States of America, published in 2015, version 3 and/or
- BIM-reference for Germany, file reference 10.08.17.7-12.08, published in 2013 and/or
- British Standard 8536-2:2016 and/or
- ONORM A 6241-2:2015.

The building model 10 preferably also comprises one or more HAYSTACK tags such as tags describing occupancy detectors, CO₂ sensors, sensors recording signals indicative of volatile organic compounds, temperature sensors, etc. Air conveyors such as fans can also be described using HAYSTACK tags of the building model 10.

It is envisaged that the occupancy detector comprises a passive infrared sensor. It is even envisaged that the occupancy detector is a passive infrared sensor.

The occupancy detector can also use radio-frequent signals to estimate and/or to determine occupancy. For example, the patent US10410511B2 deals with using a wireless enabled device and values of received signal strength to determine occupancy. The patent US10410511B2 was granted on 10 September 2019.

The building model 10 is the basis for carrying out occupancy management as illustrated by item 11. Occupancy management 11 preferably yields or proposes occupancy data for the structure. That is, data are produced and/or generated and/or proposed wherein a space r within the structure is occupied. Occupancy of a space *r* can, by way of non-limiting example, be specified in terms of numbers of people in the space *r*. Occupancy of a space *r* can, by way of another non-limiting example, be specified as a percentage of full occupancy of the space *r*. Likewise, data can be produced and/or generated and/or proposed wherein a room *r* within the building is occupied. Occupancy of a room *r* can, by way of non-limiting example, be specified in terms of numbers of people in the room *r*. Occupancy of a room *r* can, by way of another non-limiting example, be specified as a percentage of full occupancy of the room *r*.

Scenarios for occupancy management 11 can be ranked according to
- indoor air quality,
- energy conversion,
- occupant satisfaction.

The latter can be estimated using the building model 10. Occupant satisfaction can also be estimated using one or more surveys.

It is possible to specify which of the above scenarios is prioritised. More specifically, an operator of a building specifies which of the above scenarios is prioritised. A default setting is envisaged wherein energy conversion is minimised and acceptance is maximised while meeting desired indoor air quality requirements. This ideally involves assigning occupants to specific desks, zones, spaces, or rooms. These prioritisations also influence validation 13 as explained below.

Scenario analysis and ranking can be prepared using the building model 10 when the occupancy conditions are known or can be planned. For example, places exist wherein desk or room booking are mandatory, such as co-working spaces, hospitals, hospitality, event venues and/or sports facilities. Here, the integration with an indoor navigation system improves on the end-user experience.

Scenario analysis can also be performed on-demand, which is necessary for spaces with unpredictable occupancy or when occupants have greater degrees of autonomy in space usage. Likewise, occupancy of rooms or zones can be unpredictable, and occupants can have greater degrees of autonomy in room usage. To convince occupants to follow a recommended space usage per the occupancy management scenario, an occupancy management module 11 calculates and communicates gains in health and/or productivity. Gains can also pertain to energy savings, and/or to sustainability. The roles of such gains will be explained below in the notes on incentives.

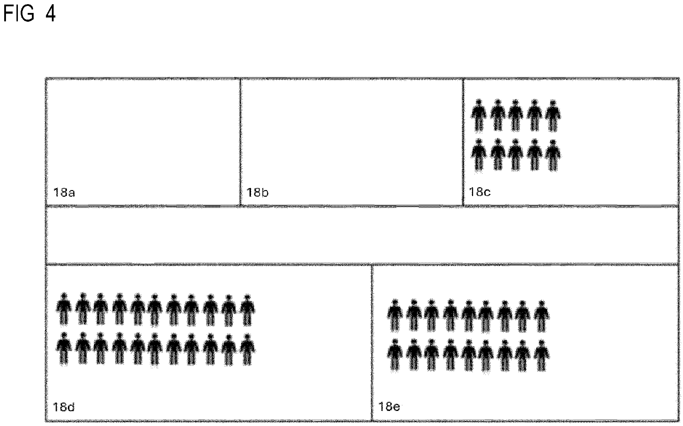

The role of the building model 10 and of occupancy management 11 is illustrated by way of FIG 4 to FIG 6. FIG 4 shows a structure having a plurality of spaces 18a - 18e. The area of space 18c is ninety square metres and ten occupants are inside this space 18c. The ten occupants yield a ventilation rate of 93 litres per second. The area of ninety square metres of space 18c yields a ventilation rate of 63 litres per second. A minimum ventilation rate for space 18c is determined based on the number of occupants present or based on the area of space 18c, whichever is greater. The minimum ventilation rate can also be calculated. It follows that the minimum ventilation rate for the space 18c in FIG 4 is 93 litres per second.

Space 18d is larger than space 18c and has an area of two hundred square metres. Twenty-two occupants are inside space 18d. The twenty-two occupants yield a ventilation rate of 205 litres per second. The area of two hundred square metres of space 18d yields a ventilation rate of 140 litres per second. A minimum ventilation rate for space 18d is determined based on the number of occupants present or based on the area of space 18d, whichever is greater. The minimum ventilation rate can also be calculated. It follows that the minimum ventilation rate for the space 18d in FIG 4 is 205 litres per second.

Space 18e is larger than space 18c and is smaller than space 18d. Space 18e has an area of one hundred fifty square metres. Eighteen occupants are inside space 18e. The eighteen occupants yield a ventilation rate of 167 litres per second. The area of one hundred fifty square metres of space 18e yields a ventilation rate of 105 litres per second. A minimum ventilation rate for space 18e is determined based on the number of occupants present or based on the area of space 18e, whichever is greater. The minimum ventilation rate can also be calculated. It follows that the minimum ventilation rate for the space 18e in FIG 4 is 167 litres per second.

The total ventilation rate for the spaces 18c to 18e as shown in FIG 4 thus becomes 465 litres per second.

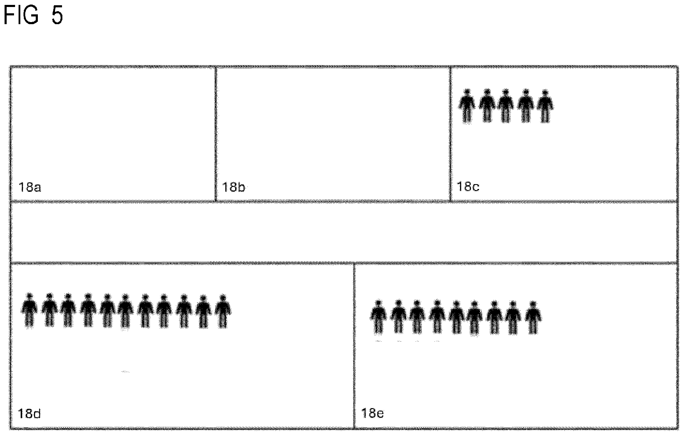

FIG 5 shows the same space wherein numbers of occupants are halved. Five occupants inside space 18c yield a ventilation rate of 46 litres per second. The area of ninety square metres of space 18c still yields a ventilation rate of 63 litres per second. A minimum ventilation rate for space 18c is determined based on the number of occupants present or based on the area of space 18c, whichever is greater. The minimum ventilation rate can also be calculated. It follows that the minimum ventilation rate for the space 18c in FIG 5 is now 63 litres per second.

Eleven occupants inside space 18d yield a ventilation rate of 102 litres per second. The area of two hundred square metres of space 18d still yields a ventilation rate of 140 litres per second. A minimum ventilation rate for space 18d is determined based on the number of occupants present or based on the area of space 18d, whichever is greater. The minimum ventilation rate can also be calculated. It follows that the minimum ventilation rate for the space 18d in FIG 5 is 140 litres per second.

Nine occupants in space 18e yield a ventilation rate of 83 litres per second. The area of one hundred fifty square metres of space 18e still yields a ventilation rate of 105 litres per second. A minimum ventilation rate for space 18e is determined based on the number of occupants present or based on the area of space 18e, whichever is greater. The minimum ventilation rate can also be calculated. It follows that the minimum ventilation rate for the space 18e in FIG 5 is 105 litres per second.

The total ventilation rate for the spaces 18c to 18e as shown in FIG 5 thus becomes 308 litres per second.

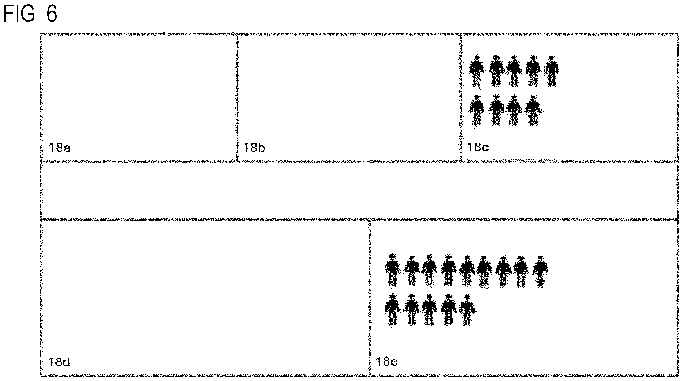

FIG 6 shows the same space wherein numbers of occupants are optimised. Compared to FIG 5, four occupants change from space 18d to space 18c and seven occupants change from space 18d to space 18e. Consequently, space 18d is now empty and needs not be ventilated.

Nine occupants inside space 18c yield a ventilation rate of 83 litres per second. The area of ninety square metres of space 18c still yields a ventilation rate of 63 litres per second. A minimum ventilation rate for space 18c is determined based on the number of occupants present or based on the area of space 18c, whichever is greater. The minimum ventilation rate can also be calculated. It follows that the minimum ventilation rate for the space 18c in FIG 6 is 83 litres per second.

Sixteen occupants inside space 18e yield a ventilation rate of 148 litres per second. The area of one hundred fifty square metres of space 18e still yields a ventilation rate of 105 litres per second. A minimum ventilation rate for space 18e is determined based on the number of occupants present or based on the area of space 18e, whichever is greater. The minimum ventilation rate can also be calculated. It follows that the minimum ventilation rate for the space 18e in FIG 6 is 148 litres per second.

The total ventilation rate for the spaces 18c to 18e as shown in FIG 6 thus becomes 231 litres per second.

Furthermore, the optimal occupancy management shown in FIG 6 improves indoor air quality by more effectively removing background pollutants, as compared to FIG 5. It is assumed that the pollutant emission rate per unit of surface is roughly the same across the entire building. The removal rate of background pollutants can then be tracked using the ventilation rate per floor area. In FIG 5, the average ventilation rate per floor area is determined and/or calculated as the total ventilation rate divided by the total occupied floor area. A total ventilation rate of 308 litres per second divided by the occupied floor area of 440 square metres yields an average ventilation rate of 0.7 litres per second and square metre. In FIG 6, a total ventilation rate of 231 litres per second divided by the occupied floor area of 240 square metres yields an average ventilation rate of 0.96 litres per second and square metre. The average ventilation rate of FIG 6 thus shows a 37 percent improvement compared to the average ventilation rate of FIG 5.

The average ventilation rate can be further improved to 1.16 litres per second and square metre by moving all occupants to space 18d. However, the rate of energy conversion is slightly higher in this case, especially when demands other than ventilation are factored in. Where the average ventilation rate is a proxy for a removal rate of background pollutants, an average rate of 1.16 litres per second further reduces background pollutants. Whether this reduction is favoured depends on the desired IAQ level and on prioritisation as explained above.

Occupancy management 11 and/or incentivization 12 as explained below are preferably handled by a server comprising a memory and one or more processors.

Occupancy management 11 can also depend on behaviour incentivisation 12. That is, one or more occupants are incentivised and/or are instructed to change their locations within the structure and/or within the building. Occupants can, by way of non-limiting example, be incentivised and/or be instructed to move to another space within the structure. Occupants can, by way of another non-limiting example, be incentivised and/or be instructed to move to another room within the building.

Incentivisation 12 can involve a mobile application on a mobile handheld device. That is, occupants receive information on proposed spaces within the structure via the mobile application. Occupants can also receive information on proposed rooms or zones within the building via the mobile application.

Choices by occupants and/or users result from incentivisation 12 and can be used to determine the acceptance rate related to a space, a desk, a room, or a zone. An acceptance rate can also be calculated. If the occupancy management 11 is integrated with a productivity or workplace management tool, personalised preferences and/or acceptance rates can be managed. Management of personalized preferences and/or of acceptance rates preferably depends on an occupant wishing to enable such feature. Management of personalized preferences and/or of acceptance rates can also depend on a user wishing to enable such feature.

The effectiveness of occupancy management 11 and/or of incentivisation 12 eventually requires validation. Validation is indicated as item 13 in FIG 3. Validation 13 advantageously involves a comparison between proposed occupancy and system data and/or algorithmic data 5. More specifically, proposed occupancy *βᵣₜ* within the various spaces *r* of a structure can be compared to actual occupancy *αᵣ.* The comparison can be carried out by determining one or more sums *ABₛᵢₜₑ* of squared deviations between proposed and actual occupancy: ${AB}_{site} = {\sum }_{r} {\sum }_{t} {\left({α}_{rt}-{β}_{rt}\right)}^{2}$

Proposed occupancy *βᵣₜ* within the various rooms or zones *r* of a building can also be compared to actual occupancy *αᵣ.* The comparison can be carried out by determining one or more sums *AB_{building}* of squared deviations between proposed and actual occupancy: ${AB}_{building} = {\sum }_{r} {\sum }_{t} {\left({α}_{rt}-{β}_{rt}\right)}^{2}$

The one or more sums *ABₛᵢₜₑ, AB_{building}* can also be calculated.

Validation 13 advantageously also involves a comparison between target levels of pollutants and system data and/or algorithmic data 5. More specifically, target levels of pollutants *qᵣₜ* within the various spaces *r* of a structure can be compared to actual levels of pollutants *pᵣₜ.* The comparison can be carried out by determining one or more sums *PQₛᵢₜₑ* of squared deviations between proposed and actual levels of pollutants: ${PQ}_{site} = {\sum }_{r} {\sum }_{t} {\left({p}_{rt}-{q}_{rt}\right)}^{2}$

It is also envisaged to normalise this expression (and other expressions): ${PQ}_{site} = {\sum }_{r} {\sum }_{t} {\left(\frac{{p}_{rt} - {q}_{rt}}{{q}_{rt}}\right)}^{2}$

It is still envisaged to factor in a plurality of pollutants, wherein individual pollutants are indexed as i. The above expressions then read ${PQ}_{site , i} = {\sum }_{r} {\sum }_{t} {\left({p}_{rt , i}-{q}_{rt , i}\right)}^{2}$ and ${PQ}_{site , i} = {\sum }_{r} {\sum }_{t} {\left(\frac{{p}_{rt , i} - {q}_{rt , i}}{{q}_{rt , i}}\right)}^{2}$

Actual levels of pollutants in the one or more spaces *r* of a structure can, by way of non-limiting example, be obtained from measurements. To that end, sensors recording signals indicative of volatile organic compounds can be placed in the one or more spaces *r*. Target levels of pollutants *qᵣₜ* within the various rooms or zones *r* of a building can also be compared to actual levels of pollutants *pᵣₜ.* The comparison can be carried out by determining one or more sums *PQ_{building}* of squared deviations between proposed and actual levels of pollutants: ${PQ}_{building} = {\sum }_{r} {\sum }_{t} {\left({p}_{rt}-{q}_{rt}\right)}^{2}$

It is also envisaged to normalise this expression (and other expressions): ${PQ}_{building} = {\sum }_{r} {\sum }_{t} {\left(\frac{{p}_{rt} - {q}_{rt}}{{q}_{rt}}\right)}^{2}$

It is still envisaged to factor in a plurality of pollutants, wherein individual pollutants are indexed as i. The above expressions then read ${PQ}_{building , i} = {\sum }_{r} {\sum }_{t} {\left({p}_{rt , i}-{q}_{rt , i}\right)}^{2}$ and ${PQ}_{building , i} = {\sum }_{r} {\sum }_{t} {\left(\frac{{p}_{rt , i} - {q}_{rt , i}}{{q}_{rt , i}}\right)}^{2}$

Actual levels of pollutants in the one or more rooms or zones *r* of a building can, by way of non-limiting example, be obtained from measurements. To that end, sensors recording signals indicative of volatile organic compounds can be placed in the one or more rooms or zones *r*. The one or more sums *PQₛᵢₜₑ, PQ_{building}* can also be calculated.

Validation 13 advantageously still further involves a comparison between target levels of CO₂ and system data and/or algorithmic data 5. More specifically, target levels of CO₂ *dᵣₜ* within the various spaces *r* of a structure can be compared to actual levels of CO₂ *cᵣₜ.* The comparison can be carried out by determining one or more sums *CDₛᵢₜₑ* of squared deviations between proposed and actual levels of CO₂: ${CD}_{site} = {\sum }_{r} {\sum }_{t} {\left({c}_{rt}-{d}_{rt}\right)}^{2}$

Actual levels of CO₂ in the one or more spaces *r* of a structure can, by way of non-limiting example, be obtained from measurements. To that end, sensors recording signals indicative of CO₂ can be placed in the one or more spaces *r*. These sensors can also be placed in supply and return ducts connected to these spaces *r*. Target levels of CO₂ *dᵣₜ* within the various rooms or zones *r* of a building can also be compared to actual levels *cᵣₜ* of CO₂. The comparison can be carried out by determining one or more sums *CD_{building}* of squared deviations between proposed and actual levels of CO₂: ${CD}_{building} = {\sum }_{r} {\sum }_{t} {\left({c}_{rt}-{d}_{rt}\right)}^{2}$

Actual levels of CO₂ in the one or more rooms or zones *r* of a building can, by way of non-limiting example, be obtained from measurements. To that end, sensors recording signals indicative of CO₂ can be placed in the one or more rooms or zones *r*. These sensors can also be placed in supply and return ducts connected to these rooms or zones *r*.

The one or more sums *CDₛᵢₜₑ, CD_{building}* can also be calculated.

Validation 13 advantageously also involves a comparison between target levels of thermal performance and system data and/or algorithmic data 5. More specifically, target levels of thermal performance *tᵣₜ* within the various spaces *r* of a structure can be compared to actual levels of thermal performance *sᵣₜ.* The comparison can be carried out by determining one or more sums *STₛᵢₜₑ* of squared deviations between proposed and actual levels of thermal performance: ${ST}_{site} = {\sum }_{r} {\sum }_{t} {\left({s}_{rt}-{t}_{rt}\right)}^{2}$

Actual levels of thermal performance in the one or more spaces *r* of a structure can, by way of non-limiting example, be obtained from measurements. To that end, sensors recording signals indicative of thermal performance such as heat meters can be placed in the one or more spaces *r*. Target levels of thermal performance *tᵣₜ* within the various rooms or zones *r* of a building can also be compared to actual levels of thermal performance *sᵣₜ.* The comparison can be carried out by determining one or more sums *ST_{building}* of squared deviations between proposed and actual levels of thermal performance: ${ST}_{building} = {\sum }_{r} {\sum }_{t} {\left({s}_{rt}-{t}_{rt}\right)}^{2}$

Actual levels of thermal performance in the one or more rooms or zones *r* of a building can, by way of non-limiting example, be obtained from measurements. To that end, sensors recording signals indicative of thermal performance such as heat meters can be placed in the one or more rooms or zones *r*.

The one or more sums *STₛᵢₜₑ, ST_{building}* can also be calculated.

Once one or more of the sums *ABₛᵢₜₑ, AB_{building}, PQₛᵢₜₑ, PQ_{building}, CDₛᵢₜₑ. CD_{building},STₛᵢₜₑ, ST_{building}* have been determined, validation 13 proceeds based on one or more of these items. Validation 13 can also proceed once one or more of the sums *ABₛᵢₜₑ, AB_{building},PQₛᵢₜₑ, PQ_{building},CDₛᵢₜₑ,CD_{building},STₛᵢₜₑ, ST_{building}* have been calculated.

In an embodiment, a validation sum *VSₛᵢₜₑ* is determined ${VS}_{site} = ab ⋅ {AB}_{site} + pq ⋅ {PQ}_{site} + cd ⋅ {CD}_{site} + st ⋅ {PQ}_{site}$ $0 \leq ab \leq 1$ $0 < pq \leq 1$ $0 \leq cd \leq 1$ $0 \leq st \leq 1$ and minimised. The validation sum *VSₛᵢₜₑ* can also be calculated and be minimised. The coefficients *ab, pq, cd, st* are chosen such that optimisations and validations 13 are not limited to energy conversion.

It is envisaged that the weights are normalised such that $ab ⋅ + pq ⋅ + cd ⋅ + st ⋅ = 1 .$

Moreover, the weights can be adjusted from factory settings over time. In an embodiment, Bayesian inference is used to adjust the weights.

In another embodiment, a validation sum *VS_{building}* is determined ${VS}_{building} = ab ⋅ {AB}_{building} + pq ⋅ {PQ}_{building} + cd ⋅ {CD}_{building} + st ⋅ {PQ}_{building}$ $0 \leq ab \leq 1$ $0 < pq \leq 1$ $0 \leq cd \leq 1$ $0 \leq st \leq 1$ and minimised. The validation sum *VS_{building}* can also be calculated and be minimised. The coefficients *ab, pq, cd, st* are chosen such that optimisations and validations 13 are not limited to energy conversion.

It is envisaged that the weights are normalised such that $ab ⋅ + pq ⋅ + cd ⋅ + st ⋅ = 1 .$

Moreover, the weights can be adjusted from factory settings over time. In an embodiment, Bayesian inference is used to adjust the weights.

The loop as illustrated in FIG 3 between system data and/or algorithmic data 5 on the one hand and workflow items 9 on the other hand continues as occupancy is optimised. It is envisaged that the loop continues endlessly.

Personnel can be instructed to change offices, spaces or rooms. Personnel can also be incentivised to make such changes. To that end, various incentives 14 can be offered. These incentives interact with the workflow items of occupancy management 11 and incentivisation 12.

Incentives 14 can, by way of non-limiting example, focus on health and/or productivity 15. Employees and workers will be interested to work in a place with minimum pollutants. Environments with excessive occupant-emitted pollutants can impair productivity and comfort because such pollutants impair indoor air quality.

In an embodiment, a score pertaining to health and/or productivity is determined or calculated. The score can be determined or can be calculated based on at least one of:
- concentrations of CO₂,
- concentrations of VOCs,
- concentrations of particulate matter such as PM*_{2.5}*.

The score can also be determined or can be calculated based on at least two of:
- concentrations of CO₂,
- concentrations of VOCs,
- concentrations of particulate matter such as PM*_{2.5}*.

The score can still be determined based on concentrations of CO₂ and based on concentrations of VOCs and based on concentrations of particulate matter such as PM*_{2.5}*. It is also envisaged that the score pertaining to health and/or productivity is calculated in this manner.

Health impacts such as any of the above scores can then be presented to occupants in the form of an air quality index. For example, an air quality index is presented on the internet at hftps://www.airnow.gov/agi/agi-basics/.

This air quality index uses colors green, yellow, orange and red to indicate the levels of concern good, moderate, unhealthy for sensitive groups and unhealthy. The level of concern will be good if the index is below fifty-one points. The level of concern will be *moderate* if the index is above fifty points and below one hundred points. The level of concern will be *unhealthy for sensitive groups* if the index is between 101 and 150 points. The level of concern will finally be *unhealthy* if the index is above 150 points.

Health impacts such as any of the above scores can also be presented to occupants in the form of Disability-Adjusted Life Years (DALYS). This approach was chosen by J LOGUE and co-authors in an article titled a method to estimate the chronic health impact of air pollutants in U.S. residences. The article was published in 2012 in the journal Environmental Health Perspectives*.* In their article, J LOGUE and co-authors demonstrate a methodology to quantify and compare health impacts from indoor air pollutants. In so doing, particulate matter with sizes less than 2.5 micrometers, acrolein (propenal) and formaldehyde are considered. Impacts of those substances were on par or even greater than those impacts from secondhand tobacco smoke and radon. J LOGUE and co-authors conclude that inhalation of those substances yields significant annual losses of disability-adjusted life years per one hundred thousand persons.

It is also possible to quantify impacts of pollutants such as VOCs on productivity. In an article published in 2016 by J ALLEN and co-authors, a relationship between indoor environmental quality and cognitive scores was investigated. To that end, two dozen participants of a study spent six workdays in a space with varying exposure to conditions of indoor environmental quality. The authors find that cognitive scores were, on average, sixty-one percent better on a green building day and were one hundred and one percent better on two green+ working days. Participants were exposed to less than 800 ppm of CO₂ on green days and to less than 650 ppm of CO₂ on green+ days. The concentrations of CO₂ on a conventional day and on a moderate day were around 950 ppm. The concentration of CO₂ on a day with high exposure to CO₂ was around 1400 ppm. Concentrations of total volatile organic compounds were below sixty micrograms per cubic meters on all days except for conventional days. On a day labelled as *conventional,* the concentration of total volatile organic compounds exceeded five hundred micrograms per cubic meters.

In this study, volatile organic compounds and CO₂ were independently associated with cognitive scores. It follows that a productivity score can be derived from concentrations of VOCs and of CO₂.

According to an aspect of the present disclosure, incentives 14, 15 pertaining to health and/or productivity are abstracted as one or more tokens. The one or more tokens can be collected or spent or transacted upon. In an embodiment, one or more tokens can be collected and spent. More specifically, occupants and/or users can collect and spend the one or more tokens. In another embodiment, the one or more tokens can be spent and transacted upon. More specifically, occupants and/or users can spend and transact upon the one or more tokens. In still another embodiment, the one or more tokens can be collected and transacted upon. More specifically, users and/or occupants can collect and transact upon the one or more tokens. It is also envisaged that the one or more tokens can be collected and spent and transacted upon. More specifically, occupants and/or users can collect and spend and transact upon the one or more tokens.

It is envisaged that any of the above tokens pertaining to health and/or productivity comprises a digital token. Any token of the above tokens pertaining to health and/or productivity can even be a digital token. Any token of the above tokens pertaining to health and/or productivity can comprise a non-fungible token. Any token of the above tokens pertaining to health and/or productivity can even be a non-fungible token.

An organisation can also choose to allow occupants and/or users to redeem tokens for tangible rewards. Values of such tangible rewards can, by way of non-limiting example, be determined based on the monetary value of improved productivity. For example, the monetary value can be determined or can be calculated as a function of an hourly pay rate and of the percentage improvement in productivity. Values of such tangible rewards can, by way of another non-limiting example, be determined or calculated based on the monetary value of lower energy conversion. The usefulness of this tokenization system is not limited to space utilization and occupancy management. What's more, an organisation can use the token system to track the success and/or the acceptance rate of assignments as explained hereinafter. An organisation can also use the token system to track the success and/or the acceptance rate of recommendations as explained hereinafter.

Incentives 14 can, by way of another non-limiting example, focus on energy conversion 16. When numbers of personnel in the spaces of a structure are optimised, fewer spaces need be cooled or heated to a comfort temperature. Since fewer spaces need be cooled or heated, less thermal power will be required. Likewise, when numbers of personnel in the rooms or zones of a building are optimised, fewer rooms need be cooled or heated to a comfort temperature. Since fewer rooms or zones need be cooled or heated, less thermal power will be required.

It is envisaged that reductions in energy conversion are quantified in terms of Kilowatt-hours or Megawatt hours. It is also envisaged that reductions in energy conversion are quantified in terms of a monetary value of such savings. More specifically, the latter score can be considered where energy pricing is dynamic.

According to an aspect of the present disclosure, incentives 14, 16 are allocated to occupants depending on change. For example, occupants can receive one or more incentives 14, 16 as a reward for changing from a preferred meeting room to a recommended meeting room. Occupants can also receive one or more incentives 14, 16 as a reward for changing from a preferred meeting room to an assigned meeting room. Likewise, occupants can receive one or more incentives 14, 16 as a reward for changing from a preferred desk to a recommended desk. Occupants can also receive one or more incentives 14, 16 as a reward for changing from a preferred desk to an assigned desk.

Numbers and amounts of these incentives pertaining to changes by occupants can be derived from average values, wherein the average values are based on structure-specific historical data. Numbers and amounts of these incentives can also be derived from average values, wherein the average values are based on building-specific historical data. It is also envisaged that numbers and amounts of these incentives are derived from average values, wherein the average values are based on structure-sector dependent data. It is still envisaged that numbers and amounts of these incentives are derived from average values, wherein the average values are based on building-sector dependent data.

In an embodiment, an occupant chooses a baseline scenario for determining or for calculating reductions in energy conversion. In an alternate embodiment, a building operator chooses a baseline scenario for determining or for calculating reductions in energy conversion.

According to an aspect of the present disclosure, incentives 14, 16 pertaining to reductions in energy conversion are abstracted as one or more tokens. The one or more tokens can be collected or spent or transacted upon. In an embodiment, at the one or more tokens can be collected and spent. More specifically, occupants and/or users can collect and spend the one or more tokens. In another embodiment, the one or more tokens can be spent and transacted upon. More specifically, occupants and/or users can spend and transact upon the one or more tokens. In still another embodiment, the one or more tokens can be collected and transacted upon. More specifically, occupants and/or users can collect and transact upon the one or more tokens. It is also envisaged that the one or more tokens can be collected and spent and transacted upon. More specifically, occupants and/or users can collect and spend and transact upon the one or more tokens.

It is envisaged that any of the above tokens pertaining to reductions in energy conversion comprises a digital token. Any token of the above tokens pertaining to reductions in energy conversion can even be a digital token. Any token of the above tokens pertaining to reductions in energy conversion can comprise a non-fungible token. Any token of the above tokens pertaining to reductions in energy conversion can even be a non-fungible token.

Incentives 14 can, by way of another non-limiting example, be linked to sustainability 17. Concerns about global warming and about emissions of greenhouse gases such as CO₂ are rife. Employees and workers may be motivated to contribute to lower emissions of greenhouse gases.

It is envisaged that improvements on sustainability are quantified in terms of avoided emissions of greenhouse gases. Greenhouse gases can, by way of non-limiting example, comprise CO₂ and/or SF₆. Avoided emissions of greenhouse gases can be further quantified in terms grams or Kilograms of avoided emissions. More specifically, avoided emissions of CO₂ can be further quantified in terms of grams or Kilograms of CO₂. Avoided emissions of SF₆ can also be quantified in terms of grams or Kilograms of SF₆.

In an embodiment, improvements on sustainability are presented in more easily understood terms such as *hours of lighting saved.* Similarly, improvements on sustainability can be presented in more easily understood terms such as *kilometers of driving avoided.* Improvements on sustainability can also be presented in more easily understood terms such as *hours of lighting saved and kilometers of driving avoided.*

According to an aspect of the present disclosure, incentives 14, 17 pertaining to sustainability are abstracted as one or more tokens. The one or more tokens can be collected or spent or transacted upon. In an embodiment, at the one or more tokens can be collected and spent. More specifically, occupants and/or users can collect and spend the one or more tokens. In another embodiment, the one or more tokens can be spent and transacted upon. More specifically, occupants and/or users can spend and transact upon the one or more tokens. In still another embodiment, the one or more tokens can be collected and transacted upon. More specifically, occupants and/or users can collect and transact upon the one or more tokens. It is also envisaged that the one or more tokens can be collected and spent and transacted upon. More specifically, occupants and/or users can collect and spend and transact upon the one or more tokens.

It is envisaged that any of the above tokens pertaining to sustainability comprises a digital token. Any token of the above tokens pertaining to sustainability can even be a digital token. Any token of the above tokens pertaining to sustainability can comprise a non-fungible token. Any token of the above tokens pertaining to sustainability can even be a non-fungible token.

In an embodiment, the same type of token is used to incentivise occupants for improved health and/or productivity and for reduced in energy conversion. More specifically, the same type of digital token is used to incentivise occupants for improved health and/or productivity and for reduced in energy conversion. Likewise, the same type of token can be used to incentivise occupants for improved health and/or productivity and for improved sustainability. More specifically, the same type of digital token can be used to incentivise occupants for improved health and/or productivity and for improved sustainability. The same type of token can still be used to incentivise occupants for reduced energy conversion and for improved sustainability. More specifically, the same type of digital token can be used to incentivise occupants for reduced energy conversion and for improved sustainability. Preferably, the same type of token is used to incentivise occupants for improved health and/or productivity and for reduced energy conversion and for improved sustainability. Ideally, the same type of digital token is used to incentivise occupants for improved health and/or productivity and for reduced energy conversion and for improved sustainability.

Occupants typically base their space utilization choices on heuristics. For example, occupants can use their *usual spot* and/or their usual desk. Occupants can also use the least occupied space and/or the least occupied room. Occupants can choose to sit closer or further away from break areas. Occupants can also choose to structure closer or further away from the nearest table for playing table tennis.

Those choices do generally not align with recommended choices that originate from any of the above determinations or calculations. Those choices do generally not align with an optimised occupancy, wherein the occupancy is optimised in view of indoor air quality and/or low energy conversion.

To encourage occupants to accept an assignment and/or a recommendation, the assignment and/or the recommendation needs be effortless. Ideally, the assignment and/or the recommendation is integrated into existing productivity tools such as mail clients. The assignment and/or the recommendation can also be integrated into existing productivity tools such as telephony software. The assignment and/or the recommendation can also be integrated into workplace management applications such as Enlighted connect. A workplace management application such as Enlighted connect is, by way of non-limiting example, available on the Internet at hitps://my.eu.comfyapp.com/login/#welcome.

For example, a desk and/or a meeting room can be assigned. A desk and/or a meeting room can also be recommended. It is envisaged that the assignment and/or the recommendation is integrated into at least one of:
- a mail client,
- a telephony software,
- a workplace management application.

It is envisaged that the assignment and/or the recommendation is integrated into at least two of:
- a mail client,
- a telephony software,
- a workplace management application.

It is even envisaged that the assignment and/or the recommendation is integrated into a mail client and into a telephony software and into a workplace management application.

According to an aspect of the present disclosure, the optimal scenario as determined by the occupancy management module 11 is presented as a default choice. The optimal scenario as determined by the occupancy management module 11 is typically presented to an occupant. Likewise, the optimal scenario as calculated by the occupancy management module 11 can be presented as a default choice. The optimal scenario as calculated by the occupancy management module 11 is typically presented to an occupant.

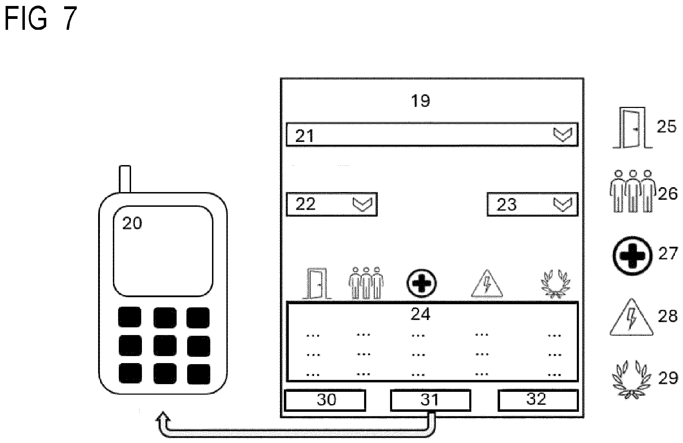

FIG 7 shows a user interface 19, wherein a recommendation is presented to a user. The user interface 19 can, by way of non-limiting example, be part of a desk finder application. The desk finder application is typically installed and is configured to run on a mobile handheld device 20. More specifically, the desk finder application can be installed and can run on the mobile handheld device 20. The mobile handheld device 20 can, by way of non-limiting example, comprise a mobile phone, a tablet computer or a laptop computer. It is even envisaged that the mobile handheld device 20 is, by way of non-limiting example, a mobile phone, a tablet computer or a laptop computer.

Typically, the user interface 19 allows occupants to choose a structure 21 and/or a building 21. In the example shown in FIG 7, occupants can also choose a start time 22 and an end time 23. Occupants can, by way of non-limiting example, start work between 6 a.m. and 9 a.m. Occupants can, by way of another non-limiting example, finish work between 3 p.m. and 7 p.m.

One or more recommendations 24 are then presented to occupants and/or to users. In the example shown in FIG 7, three recommendations 24 are presented. Likewise, one or more assignments 24 can then be presented to occupants and/or to users. In the example shown in FIG 7, three assignments 24 are presented.

A recommendation and/or an assignment 24 typically comprises a number of a space 25 of the structure 21. A capacity 26 of the space 25 can be presented alongside the number of the space 25. A recommendation and/or an assignment 24 can also comprise a number of a room 25 of the building 21. A capacity 26 of the room 25 can be presented alongside the number of the room 25.

Occupants and/or users are preferably incentivised with an indication of gains 27 in health and/or productivity. Occupants and/or users are preferably also incentivised with an indication of reductions 28 in energy conversion. The reductions 28 in energy conversion can, by way of non-limiting example, be presented as a physical quantity such as Kilowatt-hours or Megawatt-hours. Occupants and/or users can still be incentivised with an indication of gains 29 in sustainability. The gains 29 in sustainability can, by way of non-limiting example, be presented in the form of tokens such as digital tokens and/or non-fungible tokens.

According to an aspect of the present disclosure, at least one incentive selected from
- gains 27 in health and/or productivity,
- reductions 28 in energy conversion,
- gains 29 in sustainability
is presented to occupants and/or to users. According to another aspect of the present disclosure, at least two incentives selected from
- gains 27 in health and/or productivity,
- reductions 28 in energy conversion,
- gains 29 in sustainability
are presented to occupants and/or to users. It is even envisaged that gains 27 in health and/or productivity and reductions 28 in energy conversion and gains 29 in sustainability are presented.

The incentives 27 to 29 of the user interface 19 as listed in the above description are not exhaustive.

To further promote the acceptance of assignments and/or recommendations, the user interface 19 can provide one or more buttons 30 to 32. An optional button 30 in the lower left corner of the user interface 19 affords comparisons between assignments and/or between recommendations 24. That is, occupants and/or users can select two or more assignments 24 from a list and compare these assignments 24 to one another. Assignments 24 can, by way of non-limiting example, be compared to one another in terms of the incentives 27 to 29 that are also displayed by the user interface 19. Assignments 24 can, by way of another non-limiting example, be compared to one another in terms of a subset of the incentives 27 to 29.

Users and/or occupants can also select two or more recommendations 24 from the list and compare these recommendations to one another. Recommendations 24 can, by way of non-limiting example, be compared to one another in terms of the incentives 27 to 29 that are also displayed by the user interface 19. Recommendations 24 can, by way of another non-limiting example, be compared to one another in terms of a subset of the incentives 27 to 29.

Another optional button 31 leads occupants and/or users to a navigation system such as an indoor navigation system. The indoor navigation system shows occupants and/or users where to find an assigned space 25 within the structure 21. Likewise, the indoor navigation system can show occupants and/or users where to find a recommended space 25 within the structure 21. The indoor navigation system can also show occupants and/or users where to find an assigned room 25 within the building 21. Likewise, the indoor navigation system can show occupants and/or users where to find a recommended room 25 within the building 21.

In a special embodiment, the functionality of button 31 is integrated in the list of assignments and/or recommendations 24. That is, occupants and/or users can click on an assignment 24 as displayed in the list and be guided by the indoor navigation system. Likewise, occupants and/or users can click on a recommendation 24 as displayed in the list and be guided by the indoor navigation system.

Yet another optional button 32 affords bookings by occupants and/or by users. Occupants and/or users can select a space 25 within the structure 21 from the list of assignments 24 and can go ahead with booking the space 25. Likewise, occupants and/or users can select a space 25 within the structure 21 from the list of recommendations 24 and can go ahead with booking the space 25. Occupants and/or users can also select a room 25 within the building 21 from the list of assignments 24 and can go ahead with booking the room 25. Likewise, occupants and/or users can select a room 25 within the building 21 from the list of recommendations 24 and can go ahead with booking the room 25.

The buttons 30 to 32 of the user interface 19 as listed in the above description are not exhaustive.

It is envisaged that a user interface 19 comprises at least one of the buttons 30 to 32. It is still envisaged that a user interface 19 comprises at least two of the buttons 30 to 32. For example, the user interface 19 can comprise the buttons 30 and 32 with button 31 being integrated into the list of assignments and/or recommendations 24. It is even envisaged that a user interface 19 comprises all buttons 30 to 32.

It is possible that occupants and/or users override assignments 24. It is also possible that occupants and/or users override recommendations 24. In an embodiment, the user interface 19 provides a dialog box wherein occupants and/or users can specify reasons for overriding assignments 24. In an alternate embodiment, the user interface 19 provides a dialog box wherein occupants and/or users can specify reasons for overriding recommendations 24. In so doing, occupants and/or users can report issues such as headaches and/or odor. Those issues can then be tracked and can be associated with spaces 25 within the structure 21. Those issues can also be tracked and can be associated with rooms 25 within the building 21.

By default, the user interface 19 shows the optimal assignments and/or recommendations 24. The optimal assignments and/or recommendations 24 advantageously are those with the maximum gains in indoor air quality and/or with the lowest energy conversion. The optimal assignments and/or recommendations 24 can also be ranked in accordance with at least two of:
- indoor air quality,
- energy conversion,
- acceptance rate.

Preferably, indoor air quality is always a criterion that is factored in when optimal assignments and/or recommendations 24 are ranked. The optimal assignments and/or recommendations 24 can still be ranked in accordance with indoor air quality and energy savings and acceptance rate.

According to an aspect of the present disclosure, an organisation communicates any reasoning behind these rankings to achieve transparency.

In a special embodiment, a cap and trade-like approach is implemented. The cap and trade-like approach allows occupants and/or users to be rewarded when making a choice such as a sustainable choice. The reward can, by way of non-limiting example, be any of the tokens as mentioned above. The cap and trade-like approach also allows occupants and/or users to spend one or more tokens when they override assignments and/or recommendations 24.

Incentives can also be purely positive such that occupants and/or users won't be penalized for unsustainable choices. With the purely positive approach, occupants and/or users will only be rewarded for sustainable choice.

Alternatively, incentives can be purely preventative. With the purely preventative approach, occupants and/or users are given a set of tokens upfront. Occupants and/or users spend tokens as they override assignments 24. Occupants and/or users can no longer override assignments 24 once all tokens are spent. Likewise, occupants and/or users also spend tokens as they override recommendations 24. Occupants and/or users can no longer override recommendations 24 once all tokens are spent.

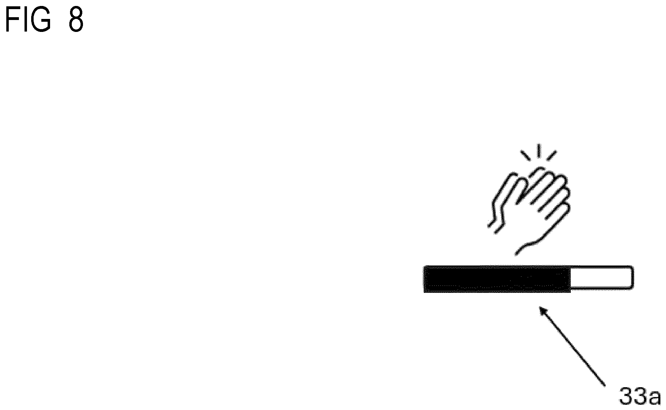

FIG 8 shows a progress tracker 33a. In the example shown in FIG 8, an occupant and/or a user has achieved at least one of:
- significant gains in health and/or productivity,
- significant reductions in energy conversion,
- significant gains in sustainability.

The occupant and/or the user can also have achieved at least two of:
- significant gains in health and/or productivity,
- significant reductions in energy conversion,
- significant gains in sustainability.

It is even possible that significant gains in health and/or productivity and significant reductions in energy conversion and significant gains in sustainability have been achieved.

The result is, by way of non-limiting example, indicated by a progress bar. Optionally, applauding hands will be displayed. The applauding hands can, by way of non-limiting example, be displayed above the progress bar.

In a special embodiment, the progress tracker 33a is part of the user interface 19 as shown in FIG 7.

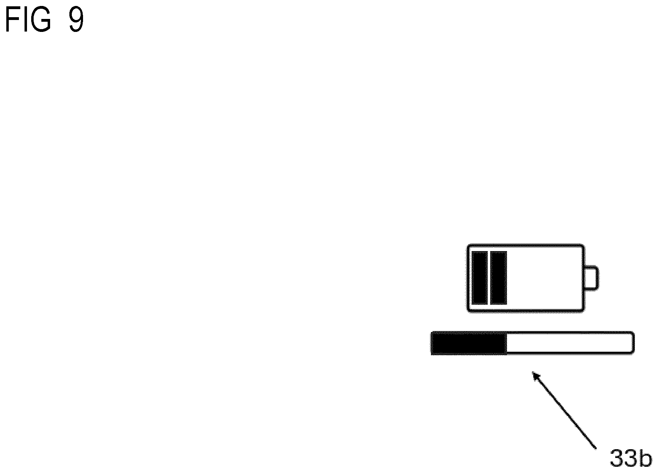

FIG 9 shows another progress tracker 33b. In the example shown in FIG 8, an occupant and/or a user has failed to achieve at least one of:
- significant gains in health and/or productivity,
- significant reductions in energy conversion,
- significant gains in sustainability.

The occupant and/or the user can also have failed to achieve at least two of:
- significant gains in health and/or productivity,
- significant reductions in energy conversion,
- significant gains in sustainability.

It is even possible that health and/or productivity and energy conversion and sustainability have deteriorated.

The result is, by way of non-limiting example, indicated by a progress bar. Optionally, an empty battery or a nearly empty battery is displayed. The empty battery and/or the nearly empty battery can, by way of non-limiting example, be displayed above the progress bar.

In a special embodiment, the progress tracker 33b is part of the user interface 19 as shown in FIG 7. It is even envisaged that the progress trackers 33a and 33b are both part of the user interface 19 as shown in FIG 7.

As described in detail herein, the present disclosure deals with a 1. A method of handling indoor air quality (IAQ) within spaces (18a - 18e) of a structure, the method comprising the steps:
using a first occupancy schedule and a building model (10) to determine a first set of ventilation rates for the spaces (18a - 18e), wherein the first occupancy schedule specifies a first distribution of a first number of occupants over the spaces (18a - 18e) and wherein the first number of occupants is lower than a maximum number, the maximum number indicating full occupancy of the structure;
using a second occupancy schedule and the building model (10) to determine a second set of ventilation rates for the spaces (18a - 18e), wherein the second occupancy schedule specifies a second distribution of the first number of occupants over the spaces (18a - 18e) and wherein the second occupancy schedule is different from the first occupancy schedule;
determining a first set of occupied spaces (18a - 18e) from the first occupancy schedule and a second set of occupied spaces (18a - 18e) from the second occupancy schedule;
determining a first ventilation rate based on the first set of occupied spaces (18a - 18e) and based on the first set of ventilation rates and associating the first ventilation rate with the first occupancy schedule;
determining a second ventilation rate based on the second set of occupied spaces (18a - 18e) and based on the second set of ventilation rates and associating the second ventilation rate with the second occupancy schedule;
selecting one of the occupancy schedules as a best IAQ schedule depending on which of the occupancy schedules is associated with a highest ventilation rate;
generating a first assignment and/or recommendation signal from the best IAQ schedule;
sending the first assignment and/or recommendation signal to a mobile handheld device (20);
the mobile handheld device (20) processing the first assignment and/or recommendation signal to obtain a first assignment and/or recommendation (24) choice; and
the mobile handheld device (20) displaying the first assignment and/or recommendation (24) choice on a user interface (19) to an occupant and/or to a user.

The present disclosure also deals with any of the aforementioned methods, wherein the method of handling indoor air quality within spaces (18a - 18e) of a structure comprises a method of improving on indoor air quality within spaces (18a - 18e) of a structure. The present disclosure still deals with any of the aforementioned methods, wherein the method of handling indoor air quality within spaces (18a - 18e) of a structure is a method of improving on indoor air quality within spaces (18a - 18e) of a structure.

The present disclosure also deals with any of the aforementioned methods, the method comprising the steps:
using the first occupancy schedule and the floor areas of the spaces (18a - 18e) to determine the first set of ventilation rates for the spaces (18a - 18e); and
using the second occupancy schedule and the floor areas of the spaces (18a - 18e) to determine the second set of ventilation rates for the spaces (18a - 18e).

The instant disclosure also deals with any of the aforementioned methods, the method comprising the steps:
using a third occupancy schedule and the building model (10) to determine a third set of ventilation rates for the spaces (18a - 18e), wherein the third occupancy schedule specifies a third distribution of the first number of occupants over the spaces (18a - 18e) and wherein the third occupancy schedule is different from the first and second occupancy schedules;
determining a third set of occupied spaces (18a - 18e) from the third occupancy schedule;
determining a third ventilation rate based on the third set of occupied spaces (18a - 18e) and based on the third set of ventilation rates and associating the third ventilation rate with the third occupancy schedule; and
selecting one of the occupancy schedules as a second-best IAQ schedule depending on which of the occupancy schedules is associated with a second-highest ventilation rate.

The present disclosure also deals with any of the aforementioned methods involving a third occupancy schedule, the method comprising the steps:
using a third occupancy schedule and the building model (10) to estimate and/or to calculate a third set of ventilation rates for the spaces (18a - 18e);
estimating and/or calculating a third set of occupied spaces (18a - 18e) from the third occupancy schedule; and
estimating and/or calculating a third ventilation rate based on the third set of occupied spaces (18a - 18e) and based on the third set of ventilation rates and associating the third ventilation rate with the third occupancy schedule.

It is envisaged that all the above steps are estimates. It is also envisaged that all the above steps are calculations. These estimates can also be made using rooms (18a - 18e) and/or zones (18a - 18e) instead of spaces (18a - 18e) and using a building instead of a structure. Likewise, these calculations can be carried out using rooms (18a - 18e) and/or zones (18a - 18e) instead of spaces (18a - 18e) and using a building instead of a structure.

A second-highest ventilation rate is chosen from among the ventilation rates, whichever ventilation rate is the second-highest. In so doing, the ventilation rates can be determined and/or estimated and/or calculated.

The third ventilation rate can relate to numbers of occupants and/or to floor areas and/or to numbers of rooms as set out below. Likewise, the first and second ventilation rates can relate to any of these items. Where a ventilation rate relates to numbers of occupants, a personal ventilation rate PVR will be obtained.

The instant disclosure also deals with any of the aforementioned methods involving a third occupancy schedule, wherein the building model (10) comprises floor areas of the spaces (18a - 18e), the method comprising the step:
using the third occupancy schedule and the floor areas of the spaces (18a - 18e) to determine the third set of ventilation rates for the spaces (18a - 18e).

The instant disclosure also deals with any of the aforementioned methods involving a third ventilation rate, the method comprising the steps:
determining a first rate of energy conversion based on the best IAQ schedule and based on the building model (10) and associating the first rate of energy conversion with the best IAQ schedule;
determining a second rate of energy conversion based on the second-best IAQ schedule and based on the building model (10) and associating the second rate of energy conversion with the second-best IAQ schedule; and
selecting an overall optimum schedule from the best IAQ schedule and from the second-best IAQ schedule depending on which of the best IAQ schedule or the second-best IAQ schedule is associated with a lower rate of energy conversion.

In an embodiment, an overall optimum schedule is determined by minimizing a sum of all squared personal ventilation rates (PVRs) over all occupants i. That is, a sum ${\sum }_{i} {PVR}_{i}^{2}$ is minimised. Likewise, a sum ${\sum }_{i} {\left({PVR}_{i}-\overline{PVR}\right)}^{2}$ can be minimised wherein PVR is an arithmetic mean of personal ventilation rates: $\overline{PVR} = \frac{1}{n} {\sum }_{i} {PVR}_{i}$

The present disclosure also pertains to any of the aforementioned methods involving a second-best IAQ schedule, the method comprising the steps:
estimating and/or calculating a first rate of energy conversion based on the best IAQ schedule and based on the building model (10) and associating the first rate of energy conversion with the best IAQ schedule; and
estimating and/or calculating a second rate of energy conversion based on the second-best IAQ schedule and based on the building model (10) and associating the second rate of energy conversion with the second-best IAQ schedule.

It is envisaged that all the above steps are estimates. It is also envisaged that all the above steps are calculations.

The instant disclosure also deals with any of the aforementioned methods involving a third ventilation rate, the method comprising the steps:
determining a first rate of energy conversion based on the first occupancy schedule and based on the building model (10) and based on the first set of occupied spaces (18a - 18e);
determining a second rate of energy conversion based on the second occupancy schedule and based on the building model (10) and based on the second set of occupied spaces (18a - 18e);
determining a third rate of energy conversion based on the third occupancy schedule and based on the third set of occupied spaces (18a - 18e);
associating the first rate of energy conversion with the first occupancy schedule;
associating the second rate of energy conversion with the second occupancy schedule;
associating the third rate of energy conversion with the third occupancy schedule; and
selecting an overall optimum schedule from the best IAQ schedule and from the second-best IAQ schedule depending on which of the best IAQ schedule or the second-best IAQ schedule is associated with a lower rate of energy conversion.

The present disclosure also pertains to any of the aforementioned methods involving a second-best IAQ schedule, the method comprising the steps:
estimating and/or calculating a first rate of energy conversion based on the first occupancy schedule and based on the building model (10) and based on the first set of occupied spaces (18a - 18e);
estimating and/or calculating a second rate of energy conversion based on the second occupancy schedule and based on the building model (10) and based on the second set of occupied spaces (18a - 18e); and
estimating and/or calculating a third rate of energy conversion based on the third occupancy schedule and based on the third set of occupied spaces (18a - 18e).

It is envisaged that all the above steps are estimates. It is also envisaged that all the above steps are calculations. These estimates can also be made using rooms (18a - 18e) and/or zones (18a - 18e) instead of spaces (18a - 18e) and using a building instead of a structure. Likewise, these calculations can be carried out using rooms (18a - 18e) and/or zones (18a - 18e) instead of spaces (18a - 18e) and using a building instead of a structure.

It is envisaged that the floor areas are factored into the determinations and/or into the estimates and/or into the calculations of the above first and second rates of energy conversion. It is also envisaged that an outside temperature and/or outdoor air quality are factored into these determinations and/or estimates and/or calculations.

The present disclosure also pertains to any of the aforementioned methods, the method comprising the step:
comparing the occupancy schedules to one another in terms of rates of energy conversion.

The present disclosure also deals with any of the aforementioned methods involving an overall optimum schedule, the method comprising the steps:
generating a second assignment and/or recommendation signal from the overall optimum schedule;
sending the second assignment and/or recommendation signal to the mobile handheld device (20);
the mobile handheld device (20) processing the second assignment and/or recommendation signal to obtain a second assignment and/or recommendation (24) choice; and
the mobile handheld device (20) displaying the second assignment and/or recommendation (24) choice on the user interface (19) to the occupant and/or to the user.

The instant disclosure also deals with any of the aforementioned methods, the method comprising the steps:
determining a first number of occupied spaces (18a - 18e) from the first set of occupied spaces (18a - 18e);
determining a first average ventilation rate by dividing the first ventilation rate by the first number of occupied spaces (18a - 18e) and associating the first average ventilation rate with the first occupancy schedule;
determining a second number of occupied spaces (18a - 18e) from the second set of occupied spaces (18a - 18e);
determining a second average ventilation rate by dividing the second ventilation rate by the second number of occupied spaces (18a - 18e) and associating the second average ventilation rate with the second occupancy schedule; and
selecting one of the occupancy schedules as the best IAQ schedule depending on which of the occupancy schedules is associated with a highest average ventilation rate.

The present disclosure also deals with any of the aforementioned methods, the method comprising the steps:
estimating and/or calculating a first number of occupied spaces (18a - 18e) from the first set of occupied spaces (18a - 18e);
estimating and/or calculating a first average ventilation rate by dividing the first ventilation rate by the first number of occupied spaces (18a - 18e) and associating the first average ventilation rate with the first occupancy schedule;
estimating and/or calculating a second number of occupied spaces (18a - 18e) from the second set of occupied spaces (18a - 18e);
estimating and/or calculating a second average ventilation rate by dividing the second ventilation rate by the second number of occupied spaces (18a - 18e) and associating the second average ventilation rate with the second occupancy schedule; and
selecting one of the occupancy schedules as the best IAQ schedule depending on which of the occupancy schedules is associated with a highest average ventilation rate. It is envisaged that all the above steps are estimates. It is also envisaged that all the above steps are calculations. These estimates can also be made using rooms (18a - 18e) and/or zones (18a - 18e) instead of spaces (18a - 18e) and using a building instead of a structure. Likewise, these calculations can be carried out using rooms (18a - 18e) and/or zones (18a - 18e) instead of spaces (18a - 18e) and using a building instead of a structure.

A highest average ventilation rate is chosen from among the average ventilation rates, whichever average ventilation rate is higher. In so doing, the average ventilation rates can be determined and/or estimated and/or calculated.

The present disclosure also deals with any of the aforementioned methods, the method comprising the steps:
determining a first number of occupants from the first occupancy schedule;
determining a first occupant-based ventilation rate by dividing the first ventilation rate by the first number of occupants and associating the first occupant-based ventilation rate with the first occupancy schedule;
determining a second number of occupants from the second occupancy schedule;
determining a second occupant-based ventilation rate by dividing the second ventilation rate by the second number of occupants and associating the second occupant-based ventilation rate with the second occupancy schedule; and
selecting one of the occupancy schedules as the best IAQ schedule depending on which of the occupancy schedules is associated with a highest occupant-based ventilation rate.

The instant disclosure also pertains to any of the aforementioned methods, the method comprising the steps:
determining a first floor area based on the building model (10) and based on the first set of occupied spaces (18a - 18e);
determining a first area-based ventilation rate by dividing the first ventilation rate by the first floor area and associating the first area-based ventilation rate with the first occupancy schedule;
determining a second floor area based on the building model (10) and based on the second set of occupied spaces (18a - 18e);
determining a second area-based ventilation rate by dividing the second ventilation rate by the second floor area and associating the second area-based ventilation rate with the second occupancy schedule; and
selecting one of the occupancy schedules as the best IAQ schedule depending on which of the occupancy schedules is associated with a highest area-based ventilation rate.

In an embodiment, an area-based ventilation rate comprises a floor area-based ventilation rate. More specifically, an area-based ventilation rate can be a floor area-based ventilation rate.

The present disclosure also pertains to any of the aforementioned methods, the method comprising the step:
comparing the occupancy schedules to one another in terms of ventilation rates such as average ventilation rates and/or minimum ventilation rates.

The instant disclosure also deals with a system comprising a structure having a plurality of spaces (18a - 18e), a server having one or more processors and a memory, the system comprising a mobile handheld device (20), wherein the memory stores a building model (10) and a first number of occupants, wherein the first number of occupants is lower than a maximum number, the maximum number indicating full occupancy of the structure, wherein the mobile handheld device (20) comprises a user interface (19), wherein the one or more processors of the server are configured to:
load the building model (10) and the first number of occupants from the memory;
generate or receive first and second occupancy schedules, the first occupancy schedule specifying a first distribution of the first number of occupants over the plurality of spaces (18a - 18e), the second occupancy schedule specifying a second distribution of the first number of occupants over the plurality of spaces (18a - 18e), the first occupancy schedule being different from the second occupancy schedule;

use the first occupancy schedule and the building model (10) to determine a first set of ventilation rates for the plurality of spaces (18a - 18e);
use the second occupancy schedule and the building model (10) to determine a second set of ventilation rates for the plurality of spaces (18a - 18e);
determine a first set of occupied spaces (18a - 18e) from the first occupancy schedule and a second set of occupied spaces (18a - 18e) from the second occupancy schedule;
determine a first ventilation rate based on the first set of occupied spaces (18a - 18e) and based on the first set of ventilation rates and associate the first ventilation rate with the first occupancy schedule;
determine a second ventilation rate based on the second set of occupied spaces (18a - 18e) and based on the second set of ventilation rates and associate the second ventilation rate with the second occupancy schedule;
select one of the occupancy schedules as a best indoor air quality (IAQ) schedule depending on which of the occupancy schedules is associated with a highest ventilation rate;
generate a first assignment and/or recommendation signal from the best IAQ schedule;
send the first assignment and/or recommendation signal to the mobile handheld device (20);
the mobile handheld device (20) being configured to:
receive the first assignment and/or recommendation signal and process the first assignment and/or recommendation signal to obtain a first assignment and/or recommendation (24) choice; and
display the first assignment and/or recommendation (24) choice on the user interface (19) to an occupant and/or to a user.

It is envisaged that the structure comprises or is a building. Where the structure comprises a building, the plurality of spaces (18a - 18e) comprises a plurality of rooms (18a - 18e) and/or comprises a plurality of zones (18a - 18e). Where the structure is a building, the plurality of spaces (18a - 18e) is a plurality of rooms (18a - 18e) and/or is a plurality of zones (18a - 18e). In an embodiment, the structure comprises the server. In a special embodiment, the building comprises the server.

Preferably, the mobile handheld device (20) comprises a memory, one or more processors, and a display.

In an embodiment, the memory of the server stores the maximum number.

It is envisaged that the first ventilation rate comprises or is a first total ventilation rate and that the second ventilation rate comprises or is a second total ventilation rate. A total ventilation rate is the sum of all the ventilation rates of the spaces (18a - 18e) of the structure. A total ventilation rate can also be the sum of all ventilation rates of the rooms (18a - 18e) of a building and/or of the zones (18a - 18e) of a building.

The present disclosure also pertains to any of the aforementioned systems, wherein the one or more processors of the server are configured to:
use the first occupancy schedule and the building model (10) to estimate and/or to calculate a first set of ventilation rates for the plurality of spaces (18a - 18e);
use the second occupancy schedule and the building model (10) to estimate and/or to calculate a second set of ventilation rates for the plurality of spaces (18a - 18e);
estimate and/or calculate a first set of occupied spaces (18a - 18e) from the first occupancy schedule and a second set of occupied spaces (18a - 18e) from the second occupancy schedule;
estimate and/or calculate a first ventilation rate based on the first set of occupied spaces (18a - 18e) and based on the first set of ventilation rates and associate the first ventilation rate with the first occupancy schedule; and
estimate and/or calculate a second ventilation rate based on the second set of occupied spaces (18a - 18e) and based on the second set of ventilation rates and associate the second ventilation rate with the second occupancy schedule.

It is envisaged that all the above computations are estimates. It is also envisaged that all the above computations are calculations. These estimates can also be made using rooms (18a - 18e) and/or zones (18a - 18e) instead of spaces (18a - 18e) and using a building instead of a structure. Likewise, these calculations can be carried out using rooms (18a - 18e) and/or zones (18a - 18e) instead of spaces (18a - 18e) and using a building instead of a structure.

A highest ventilation rate is chosen from among the ventilation rates, whichever is higher. In so doing, the ventilation rates can be determined and/or estimated and/or calculated.

The user can be an occupant. The user can also be different from an occupant or can become an occupant.

The instant disclosure also deals with any of the aforementioned systems, wherein the building model (10) comprises a floor area of each space (18a - 18e) of the plurality of spaces (18a - 18e), wherein the one or more processors of the server are configured to:
use the first occupancy schedule and the floor areas to determine the first set of ventilation rates for the spaces (18a - 18e); and
use the second occupancy schedule and the floor areas to determine the second set of ventilation rates for the spaces (18a - 18e).

The building model (10) advantageously comprises floor areas for the spaces (18a - 18e).

The present disclosure also pertains to any of the aforementioned systems involving floor areas, wherein the one or more processors of the server are configured to:
use the first occupancy schedule and the floor areas to estimate and/or to calculate the first set of ventilation rates for the spaces (18a - 18e); and
use the second occupancy schedule and the floor areas to estimate and/or to calculate the second set of ventilation rates for the spaces (18a - 18e).

It is envisaged that all the above computations are estimates. It is also envisaged that all the above computations are calculations. These estimates can also be made using rooms (18a - 18e) and/or zones (18a - 18e) instead of spaces (18a - 18e) and using a building instead of a structure. Likewise, these calculations can be carried out using rooms (18a - 18e) and/or zones (18a - 18e) instead of spaces (18a - 18e) and using a building instead of a structure.

Requirements for ventilation depend not only on occupants, but also on sizes of spaces (18a - 18e), rooms (18a - 18e) or zones (18a - 18e). By factoring in floor areas, occupancy management (11) comes more accurate and more nuanced. In an embodiment, maximum occupancies of the spaces (18a - 18e) are also factored in when determining and/or estimating and/or calculating the ventilation rates.

The instant disclosure also deals with any of the aforementioned systems, wherein the mobile handheld device (20) is configured to:
register, via the user interface (19), a positive feedback signal indicative of the occupant and/or the user approving the first assignment and/or recommendation (24) choice; and
send the positive feedback signal to the server.

The positive feedback signal can be indicative of the occupant and/or the user making a booking in accordance with the first assignment and/or recommendation (24) choice.

The instant disclosure also deals with any of the aforementioned systems involving a positive feedback signal, wherein the memory of the server stores a set of tokens associated with the occupant and/or with the user, wherein the one or more processors of the server are configured to:
receive the positive feedback signal;
in response to the positive feedback signal, load the set of tokens from the memory and add one or more tokens to the set of tokens; and
after adding the one or more tokens, store the set of tokens in the memory.

The present disclosure also deals with any of the aforementioned systems involving a positive feedback signal, wherein at least one space (18a - 18e) of the plurality of spaces (18a - 18e) comprises an occupancy detector coupled with the server, wherein the one or more processors of the server are configured to:
receive the positive feedback signal;
in response to the positive feedback signal, record a signal indicative of actual occupancy from the occupancy detector;
generate a signal indicative of expected occupancy from the selected occupancy schedule; and
compare the signal indicative of actual occupancy to the signal indicative of expected occupancy.

The instant disclosure also deals with any of the aforementioned systems involving a positive feedback signal, wherein at least one space (18a - 18e) of the plurality of spaces (18a - 18e) comprises an occupancy detector coupled with the server, wherein the one or more processors of the server are configured to:
receive the positive feedback signal;
wait for a predetermined time span after receipt of the positive feedback signal, then record a signal indicative of actual occupancy from the occupancy detector;
generate a signal indicative of expected occupancy from the selected occupancy schedule; and
compare the signal indicative of actual occupancy to the signal indicative of expected occupancy.

It is envisaged that the predetermined time span is less than five minutes or less than ten minutes or less than twenty minutes. It is also envisaged that the predetermined time span is fifteen minutes. One may want to wait for a predetermined time span because occupants and/or users take their time to change to a different space (18a - 18e) or room (18a - 18e) or zone (18a - 18e).

The occupancy detector is preferably coupled with the one or more processors of the server. The present disclosure also pertains to any of the aforementioned systems involving a positive feedback signal, wherein the one or more processors of the server are configured to:
generate and/or produce a signal indicative of expected occupancy from the best IAQ schedule.

The present disclosure also deals with any of the aforementioned systems involving a comparison between signals indicative of actual and expected occupancy, wherein the memory of the server stores a set of tokens associated with the occupant and/or with the user, wherein the one or more processors of the server are configured to:
if the signal indicative of actual occupancy matches the signal indicative of expected occupancy:
load the set of tokens from the memory and add one or more tokens to the set of tokens; and
after adding the one or more tokens, store the set of tokens in the memory.

The instant disclosure also deals with any of the aforementioned systems involving a comparison between signals indicative of actual and expected occupancy, wherein the memory of the server stores a set of tokens associated with the occupant and/or with the user, wherein the one or more processors of the server are configured to:
if the signal indicative of actual occupancy differs from the signal indicative of expected occupancy:
load the set of tokens from the memory;
determine a first number of tokens of the set of tokens;
remove a second number of tokens from the set of tokens, wherein the first number of tokens is greater than or equal to the second number of tokens; and
after removing the second number of tokens, store the set of tokens in the memory.

The memory of the server preferably comprises a non-volatile memory. The memory of the server ideally is a non-volatile memory.

The present disclosure also pertains to any of the aforementioned systems, wherein the one or more processors of the server are configured to:
compare the occupancy schedules to one another in terms of ventilation rates such as average ventilation rates or minimum ventilation rates or total ventilation rates.

The one or more tokens of the present disclosure are preferably stored using a blockchain and read using a blockchain. The blockchain can be stored in the memory of the server. The blockchain can also be stored outside the server. More specifically, the blockchain can be in the public domain. Storage of tokens in a blockchain mitigates issues related to manipulation of such tokens.

In an embodiment, the first ventilation rate comprises a first characteristic ventilation rate and the second ventilation rate comprises a second characteristic ventilation rate. More specifically, the first ventilation rate can be a first characteristic ventilation rate and the second ventilation rate can be a second characteristic ventilation rate. Preferably, the first ventilation rate comprises a first characteristic ventilation rate and the second ventilation rate comprises a second characteristic ventilation rate and the third ventilation rate comprises a third characteristic ventilation rate. More specifically, the first ventilation rate can be a first characteristic ventilation rate and the second ventilation rate can be a second characteristic ventilation rate and the third ventilation rate can be a third characteristic ventilation rate.

It should be understood that the foregoing relates only to certain embodiments of the disclosure. Numerous changes may be made therein without departing from the scope of the disclosure as defined by the following claims. It should also be understood that the disclosure is not restricted to the illustrated embodiments. Various modifications can be made within the scope of the following claims. ^{™}

### Reference numerals

1a - 1e: Occupants and/or users
2: CO₂ meter
3a, 3b: office equipment
4: cleaning equipment
5: system data and/or of algorithmic data
6: occupancy data
7: data indicative of indoor air quality
8: Data indicative of thermal performance
9: workflow items
10: building model
11: occupancy management (module)
12: incentivisation (module)
13: validations (module)
14: incentives
15: incentives pertaining to health and/or productivity
16: incentives pertaining to reductions in energy conversion
17: Incentives pertaining to and/or linked to sustainability.
18a - 18a: spaces and/or rooms and/or zones
19: User interface
20: mobile handheld device
21: structure selection or building selection
22: indication of start time
23: indication of end time
24: list of assignments and/or recommendations
25: identifier of a space and/or of a room and/or of a zone, the identifier can be a number
26: capacity of a space and/or of a room and/or of a zone
27: gains in health and/or productivity
28: reductions in energy conversion
29: gains in sustainability
30 - 32: buttons
33a, 33b: performance trackers

## Claims

1. A method of handling indoor air quality (IAQ) within spaces (18a - 18e) of a structure, the method comprising the steps:
using a first occupancy schedule and a building model (10) to determine a first set of ventilation rates for the spaces (18a - 18e), wherein the first occupancy schedule specifies a first distribution of a first number of occupants over the spaces (18a - 18e) and wherein the first number of occupants is lower than a maximum number, the maximum number indicating full occupancy of the structure;
using a second occupancy schedule and the building model (10) to determine a second set of ventilation rates for the spaces (18a - 18e), wherein the second occupancy schedule specifies a second distribution of the first number of occupants over the spaces (18a - 18e) and wherein the second occupancy schedule is different from the first occupancy schedule;
determining a first set of occupied spaces (18a - 18e) from the first occupancy schedule and a second set of occupied spaces (18a - 18e) from the second occupancy schedule;
determining a first ventilation rate based on the first set of occupied spaces (18a - 18e) and based on the first set of ventilation rates and associating the first ventilation rate with the first occupancy schedule;
determining a second ventilation rate based on the second set of occupied spaces (18a - 18e) and based on the second set of ventilation rates and associating the second ventilation rate with the second occupancy schedule;
selecting one of the occupancy schedules as a best IAQ schedule depending on which of the occupancy schedules is associated with a highest ventilation rate;
generating a first assignment and/or recommendation signal from the best IAQ schedule;
sending the first assignment and/or recommendation signal to a mobile handheld device (20);
the mobile handheld device (20) processing the first assignment and/or recommendation signal to obtain a first assignment and/or recommendation (24) choice; and
the mobile handheld device (20) displaying the first assignment and/or recommendation (24) choice on a user interface (19) to an occupant and/or to a user.

2. The method according to claim 1, wherein the building model (10) comprises floor areas of the spaces (18a - 18e), the method comprising the steps:
using the first occupancy schedule and the floor areas of the spaces (18a - 18e) to determine the first set of ventilation rates for the spaces (18a - 18e); and
using the second occupancy schedule and the floor areas of the spaces (18a - 18e) to determine the second set of ventilation rates for the spaces (18a - 18e).

3. The method according to any of the claims 1 to 2, the method comprising the steps:
using a third occupancy schedule and the building model (10) to determine a third set of ventilation rates for the spaces (18a - 18e), wherein the third occupancy schedule specifies a third distribution of the first number of occupants over the spaces (18a - 18e) and wherein the third occupancy schedule is different from the first and second occupancy schedules;
determining a third set of occupied spaces (18a - 18e) from the third occupancy schedule;
determining a third ventilation rate based on the third set of occupied spaces (18a - 18e) and based on the third set of ventilation rates and associating the third ventilation rate with the third occupancy schedule; and
selecting one of the occupancy schedules as a second-best IAQ schedule depending on which of the occupancy schedules is associated with a second-highest ventilation rate.

4. The method according to claim 3, the method comprising the steps:
determining a first rate of energy conversion based on the best IAQ schedule and based on the building model (10) and associating the first rate of energy conversion with the best IAQ schedule;
determining a second rate of energy conversion based on the second-best IAQ schedule and based on the building model (10) and associating the second rate of energy conversion with the second-best IAQ schedule; and
selecting an overall optimum schedule from the best IAQ schedule and from the second-best IAQ schedule depending on which of the best IAQ schedule or the second-best IAQ schedule is associated with a lower rate of energy conversion.

5. The method according to claim 3, the method comprising the steps:
determining a first rate of energy conversion based on the first occupancy schedule and based on the building model (10) and based on the first set of occupied spaces (18a - 18e);
determining a second rate of energy conversion based on the second occupancy schedule and based on the building model (10) and based on the second set of occupied spaces (18a - 18e);
determining a third rate of energy conversion based on the third occupancy schedule and based on the third set of occupied spaces (18a - 18e);
associating the first rate of energy conversion with the first occupancy schedule;
associating the second rate of energy conversion with the second occupancy schedule;
associating the third rate of energy conversion with the third occupancy schedule; and
selecting an overall optimum schedule from the best IAQ schedule and from the second-best IAQ schedule depending on which of the best IAQ schedule or the second-best IAQ schedule is associated with a lower rate of energy conversion.

6. The method according to any of the claims 4 to 5, the method comprising the steps:
generating a second assignment and/or recommendation signal from the overall optimum schedule;
sending the second assignment and/or recommendation signal to the mobile handheld device (20);
the mobile handheld device (20) processing the second assignment and/or recommendation signal to obtain a second assignment and/or recommendation (24) choice; and
the mobile handheld device (20) displaying the second assignment and/or recommendation (24) choice on the user interface (19) to the occupant and/or to the user.

7. The method according to any of the claims 1 to 6, the method comprising the steps:
determining a first number of occupied spaces (18a - 18e) from the first set of occupied spaces (18a - 18e);
determining a first average ventilation rate by dividing the first ventilation rate by the first number of occupied spaces (18a - 18e) and associating the first average ventilation rate with the first occupancy schedule;
determining a second number of occupied spaces (18a - 18e) from the second set of occupied spaces (18a - 18e);
determining a second average ventilation rate by dividing the second ventilation rate by the second number of occupied spaces (18a - 18e) and associating the second average ventilation rate with the second occupancy schedule; and
selecting one of the occupancy schedules as the best IAQ schedule depending on which of the occupancy schedules is associated with a highest average ventilation rate.

8. A system comprising a structure having a plurality of spaces (18a - 18e), a server having one or more processors and a memory, the system comprising a mobile handheld device (20), wherein the memory stores a building model (10) and a first number of occupants, wherein the first number of occupants is lower than a maximum number, the maximum number indicating full occupancy of the structure, wherein the mobile handheld device (20) comprises a user interface (19), wherein the one or more processors of the server are configured to:
load the building model (10) and the first number of occupants from the memory;
generate or receive first and second occupancy schedules, the first occupancy schedule specifying a first distribution of the first number of occupants over the plurality of spaces (18a - 18e), the second occupancy schedule specifying a second distribution of the first number of occupants over the plurality of spaces (18a - 18e), the first occupancy schedule being different from the second occupancy schedule;
use the first occupancy schedule and the building model (10) to determine a first set of ventilation rates for the plurality of spaces (18a - 18e);
use the second occupancy schedule and the building model (10) to determine a second set of ventilation rates for the plurality of spaces (18a - 18e);
determine a first set of occupied spaces (18a - 18e) from the first occupancy schedule and a second set of occupied spaces (18a - 18e) from the second occupancy schedule;
determine a first ventilation rate based on the first set of occupied spaces (18a - 18e) and based on the first set of ventilation rates and associate the first ventilation rate with the first occupancy schedule;
determine a second ventilation rate based on the second set of occupied spaces (18a - 18e) and based on the second set of ventilation rates and associate the second ventilation rate with the second occupancy schedule;
select one of the occupancy schedules as a best indoor air quality (IAQ) schedule depending on which of the occupancy schedules is associated with a highest ventilation rate;
generate a first assignment and/or recommendation signal from the best IAQ schedule;
send the first assignment and/or recommendation signal to the mobile handheld device (20);
the mobile handheld device (20) being configured to:
receive the first assignment and/or recommendation signal and process the first assignment and/or recommendation signal to obtain a first assignment and/or recommendation (24) choice; and
display the first assignment and/or recommendation (24) choice on the user interface (19) to an occupant and/or to a user.

9. The system according to claim 8, wherein the building model (10) comprises a floor area of each space (18a - 18e) of the plurality of spaces (18a - 18e), wherein the one or more processors of the server are configured to:
use the first occupancy schedule and the floor areas to determine the first set of ventilation rates for the spaces (18a - 18e); and
use the second occupancy schedule and the floor areas to determine the second set of ventilation rates for the spaces (18a - 18e).

10. The system according to any of the claims 8 to 9, wherein the mobile handheld device (20) is configured to:
register, via the user interface (19), a positive feedback signal indicative of the occupant and/or the user approving the first assignment and/or recommendation (24) choice; and
send the positive feedback signal to the server.

11. The system according to claim 10, wherein the memory of the server stores a set of tokens associated with the occupant and/or with the user, wherein the one or more processors of the server are configured to:
receive the positive feedback signal;
in response to the positive feedback signal, load the set of tokens from the memory and add one or more tokens to the set of tokens; and
after adding the one or more tokens, store the set of tokens in the memory.

12. The system according to claim 10, wherein at least one space (18a - 18e) of the plurality of spaces (18a - 18e) comprises an occupancy detector coupled with the server, wherein the one or more processors of the server are configured to:
receive the positive feedback signal;
in response to the positive feedback signal, record a signal indicative of actual occupancy from the occupancy detector;
generate a signal indicative of expected occupancy from the selected occupancy schedule; and
compare the signal indicative of actual occupancy to the signal indicative of expected occupancy.

13. The system according to claim 10, wherein at least one space (18a - 18e) of the plurality of spaces (18a - 18e) comprises an occupancy detector coupled with the server, wherein the one or more processors of the server are configured to:
receive the positive feedback signal;
wait for a predetermined time span after receipt of the positive feedback signal, then record a signal indicative of actual occupancy from the occupancy detector;
generate a signal indicative of expected occupancy from the selected occupancy schedule; and
compare the signal indicative of actual occupancy to the signal indicative of expected occupancy.

14. The system according to any of the claims 12 to 13, wherein the memory of the server stores a set of tokens associated with the occupant and/or with the user, wherein the one or more processors of the server are configured to:
if the signal indicative of actual occupancy matches the signal indicative of expected occupancy:
load the set of tokens from the memory and add one or more tokens to the set of tokens; and
after adding the one or more tokens, store the set of tokens in the memory.

15. The system according to any of the claims 12 to 13, wherein the memory of the server stores a set of tokens associated with the occupant and/or with the user, wherein the one or more processors of the server are configured to:
if the signal indicative of actual occupancy differs from the signal indicative of expected occupancy:
load the set of tokens from the memory;
determine a first number of tokens of the set of tokens;
remove a second number of tokens from the set of tokens, wherein the first number of tokens is greater than or equal to the second number of tokens; and
after removing the second number of tokens, store the set of tokens in the memory.
